# EUROPÄISCHE PATENTSCHRIFT

(11) **EP 3 210 247 B1**
(45) Veröffentlichungstag und Bekanntmachung des Hinweises auf die Patenterteilung: **25.03.2020**
(21) Anmeldenummer: 15771069.0
(22) Anmeldetag: 18.09.2015
(51) Int. Cl.: H01L 51/00, B32B 3/08, B32B 7/06, B32B 17/06

(54) **DÜNNGLASFOLIENVERBUNDBAHN MIT VERSTEIFUNGSSTREIFEN**
THIN GLASS FILM COMPOSITE WEB WITH REINFORCING STRIPS
BANDE COMPOSITE À FEUILLE DE VERRE MINCE POURVUE DE BANDES DE RENFORCEMENT

(30) Priorität: 20.10.2014 DE 102014221245
(43) Veröffentlichungstag der Anmeldung: 30.08.2017
(73) Patentinhaber: tesa SE, 22848 Norderstedt (DE)
(72) Erfinder: KEITE-TELGENBÜSCHER, Klaus, 22529 Hamburg (DE); ROMPF, Julia, 20249 Hamburg (DE); BENDEICH, Manuel, 22527 Hamburg (DE)
(86) Internationale Anmeldenummer: PCT/EP2015/071498
(87) Internationale Veröffentlichungsnummer: WO 2016/062471

(56) Entgegenhaltungen:
- JP-A- 2013 022 901
- US-A- 3 089 801
- US-A1- 2006 280 920
- US-A1- 2007 042 166

## Beschreibung

Die Erfindung betrifft eine Dünnglasfolienverbundbahn nach dem Oberbegriff des Anspruchs 1 und ein Verfahren zur Lagerung von Dünnglasfolienbahnen. Optoelektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch sogenanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante optoelektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, ferner Elektrolumineszenzlampen, Licht emittierende elektrochemische Zellen (LEECs), organische Solarzellen wie Farbstoff- oder Polymersolarzellen, anorganische Solarzellen, insbesondere Dünnschichtsolarzellen, zum Beispiel auf der Basis von Silizium, Germanium, Kupfer, Indium und Selen, Perowskitsolarzellen, organische FeldeffektTransistoren, organische Schaltelemente, organische optische Verstärker, organische Laserdioden, organische oder anorganische Sensoren oder auch organisch- oder anorganisch basierte RFID-Transponder.

Als technische Herausforderung für die Realisierung einer ausreichenden Lebensdauer und Funktion von optoelektronischen Anordnungen auf dem Gebiet der anorganischen und organischen Optoelektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von optoelektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da anderenfalls die Leistung über den Anwendungszeitraum nachlässt. Bei mangelhaftem Schutz können sich beispielsweise durch Oxidations- oder Hydrolyseprozesse bei Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Bei der anorganischen und/oder organischen (Opto-)Elektronik, insbesondere in der organischen (Opto-)Elektronik, gibt es daher einen Bedarf für flexible Substrate, die die elektronischen Komponenten schützen und eine Permeationsbarriere für Permeate wie Sauerstoff und/oder Wasserdampf darstellen.

Besonders guten Schutz vor Permeaten bietet Glas. Seit einiger Zeit existieren auf dem Markt besonders dünne und flexible Gläser, beispielsweise wurde von der Firma Corning das sogenannte Willow® Glass vorgestellt. Das extrem dünne und flexible Glas kann für elektronische Aufbauten verwendet werden und könnte die Geräteform von mobilen Endgeräten wie Smartphones und Tablets deutlich verändern.

Die Dünnglasfolien werden als 100 µm dicke Dünnglasfolien auf 1 m breiten Rollen mit einer Länge von bis zu 300 m angeboten.

Zur mechanischen Stabilisierung wird eine Dünnglasfolie oft mit einer polymeren Schutzfolie ausgerüstet. Die Schutzfolie kann permanent auf dem Glas verbleiben oder vor dem Einsatz der OLEDs in der finalen Applikation wieder entfernt werden. Die Schutzfolien werden in der Regel mit einem Klebstoff auf die Dünnglasfolie aufgebracht. Wesentlich für den breiten Einsatz von Dünnglas von der Rolle sind stabilitätserhaltende Maßnahmen; zum einen insbesondere zur Vermeidung von Spanungsrisskorrosion bei der Lagerung auf der Rolle, zum anderen ist aber ein weiterer wesentlicher Aspekt der Stabilisierung der Dünnglasfolie die Stabilisierung der Glaskante.

Aus dem Herstellungsprozess der Dünnglasfolie in dem sogenannten Down-Draw-Verfahren ist die Kante ursprünglich als Borte verdickt, siehe hierzu beispielsweise die WO 00/41978 A1. Die Borte erschwert jedoch das Aufwickeln der Dünnglasfolie zu einer Rolle, da zum einen durch die Verdickung nur ein geringer Biegeradius realisiert werden kann und zum anderen die Lagen nicht plan aufeinander zu liegen kommen. Daher wird die Borte an der Dünnglasfolie vor dem Wickeln zu einer Rolle in der Regel abgeschnitten. Die geschnittene Kante verbleibt dann als ausgesprochen empfindliche Stelle, von der leicht Glasrisse in das Innere der Dünnglasfolie ausgehen. Für Bearbeitungs- und Abscheideprozesse, denen die Dünnglasfolie in einem Verarbeitungsprozess ausgesetzt wird, ist oft eine sehr genaue Positionierung der Dünnglasfolie notwendig. Insbesondere bei der seitlichen Bahnführung der Dünnglasfolie in einem Rolle-zu-Rolle-Prozess wirken gerade auf die Kante besonders hohe Kräfte, so dass die Gefahr von Bahnrissen erhöht ist.

Es ist bekannt, dass Glas eine hohe permeationssperrende Wirkung gegenüber Wasserdampf und Sauerstoff aufweist und somit für die Verkapselung von wasserdampf- und sauerstoffempfindlichen OLEDs geeignet ist. Flexible beziehungsweise biegsame OLEDs benötigen eine flexible Verkapselung, die vorteilhaft mit einer flexiblen Dünnglasfolie realisierbar ist. Dünnglasfolien sind begrenzt biegsam und somit auch zur Herstellung von flexiblen oder biegsamen Vorrichtungen geeignet. Die Dünnglasfolie ist jedoch sehr empfindlich, und es kann zu Beschädigungen, insbesondere ausgehend von der Glaskante der Dünnglasfolie, kommen, insbesondere wenn diese beschnitten wurde.

Es sind aus dem Stand der Technik Vorrichtungen und Verfahren bekannt, die der Stabilisierung, insbesondere der Kante der Dünnglasfolie dienen.

Die JP 2013 022901 A offenbart einen Dünnglasfolienverbund mit einer Glasfolie, einer Trägerfolie und einer bandförmigen Folie in einem Kantenbereich des Dünnglasfolienverbunds.

Die WO 2011/014606 offenbart eine flexible polymere Glasbeschichtung, die an der Kante über das Glas hinausragt. Die Beschichtung kann das Glas in seiner gesamten Breite oder auch nur teilweise abdecken. Das Beschichtungsmaterial kann durch Polymere oder Glasfasern verstärkt sein. Die Beschichtung kann als Flüssigkeit oder vorgeformter Film aufgebracht werden. Als Material für den vorgeformten Film werden sowohl Polymere vorgeschlagen als auch Metall, auch in Kombination mit einem Polymer. Die seitlich an der Glasfolie herausragende flexible Glasbeschichtung dient einem einfacheren Handling der Glasfolie, das heißt, die Glasfolie kann an den beiden seitlich abstehenden Beschichtungen gegriffen werden und verbracht werden.
Nachteilig an der Glasbeschichtung ist, dass sie einen deutlich geringeren E-Modul als Glas aufweist und daher Zugbelastungen in Längsrichtung der Dünnglasfolie nachgibt, so dass die Belastung direkt auf die Kante der Dünnglasfolie übertragen wird. Des Weiteren werden die Verstärkungen in Form von Polymer- oder Glasfasern entlang der gesamten Breite der Glasbeschichtung eingebracht, so dass die Biegsamkeit insgesamt verringert wird. Auch der Zusatz von Glas- oder Polymerfasern in einem für Beschichtungen oder Polymerfolien üblichen Anteil von maximal 30 Gewichtsprozent bleibt der E-Modul der Glasbeschichtung insgesamt deutlich unterhalb dessen der Dünnglasfolie selbst.
Aus der WO 2008/069930 A2 ist ein Verbundmaterial aus einer Glasschicht und einer flexiblen polymeren Trägerschicht offenbart. Die Glasschicht ist auf der Polymerschicht angeordnet, wobei die Polymerschicht als Trägermaterial über die Kanten der Glasschicht hinausragt.
Nachteilig ist auch hier, dass die Polymerschicht einen deutlich geringeren E-Modul als die Dünnglasfolie aufweist und daher bei einer Zugbelastung der Kante der Dünnglasfolie nachgibt, so dass die Belastung auf die Kante des Glases übertragen wird.
In der US 6,815,070 B1 ist ein Glaskunststoffverbund für die Stabilisierung von Dünnglas beschrieben. Die Beschichtung des Dünnglases erfolgt mit flüssigen Polymeren. Das Aufbringen der Polymerschicht auf eine Dünnglasfolie geschieht durch Schleudern, Sprühen, Aufgießen, Aufwalzen oder Tauchen. Die Polymerbeschichtung kann auch um die Kante des Dünnglases herumreichen. Die Beschichtung weist jedoch ein homogenes Material auf, und die an der Kante sehr dünne Beschichtung ist nicht geeignet, die bei der Bahnführung an der Kante der Dünnglasfolie auftretenden Zugkräfte aufzunehmen. Auch hier weist die um die Kante geführte polymere Beschichtung einen deutlich geringeren E-Modul als das Glas selbst auf und gibt daher bei einer Zugbelastung an der Kante des Glases nach, so dass die Belastung auf die Kante der Dünnglasfolie übertragen wird.

In der EP 2 336 048 A1 werden Verbunde aus einer Dünnglasfolie und einer polymeren Trägerfolie offenbart, bei denen die Trägerfolie nicht nur in Bahnrichtung vorne und hinten über das Dünnglas hinausragt, sondern auch seitlich. Nachteilig ist auch hier, dass die flexible polymere Trägerfolie einen deutlich geringeren E-Modul als das Glas aufweist und daher bei einer Zugbelastung an der Kante der Dünnglasfolie nachgibt, so dass die Belastung auf die Kante des Glases übertragen wird und dort zu einer Rissbildung führen kann.

Die US 2010/0260964 A1 betrifft einen auf Rolle gewickelten Verbund aus einer Dünnglasfolie mit einem Trägermaterial, wobei auch hier das Trägermaterial seitlich über die Kanten der Dünnglasfolie hinausragt. Das polymere Trägermaterial oder der Schutzfilm sind/ist über die gesamte Ausdehnung homogen ausgebildet.

In der US 6,592,969 B1 ist ebenfalls ein Verbund, der auf Rolle gewickelt sein kann, aus einer Dünnglasfolie mit einem Trägermaterial offenbart, wobei auch hier das Trägermaterial seitlich über die Kanten der Dünnglasfolie hinausragt. Auch hier ist das Trägermaterial über seine gesamte Ausdehnung homogen aus demselben Material ausgebildet.

In der US 2005/0053768 A1 ist eine Glasschutzfolie mit eingeprägten Verdickungen offenbart. Die Schutzfolie kann aus einem Verbund aus einer polymeren glatten Schicht und einer rauen Schicht aus Papier oder Gewebe bestehen, aber auch eine reine Polymerschicht sein. Durch die Prägung weist die Schutzfolie Bereiche unterschiedlicher Zugsteifigkeit auf, die jedoch willkürlich über die Fläche verteilt sind und die gerade im Bereich der Kante einen Bereich geringer Zugsteifigkeit aufweisen.
Die Schutzfolie reicht darüber hinaus nicht über die Kanten hinaus. Gewebe und Papier als Verstärkungsmaterialien weisen einen deutlich geringeren E-Modul als das Glas auf und geben daher bei einer Zugbelastung an der Kante des Glases nach, so dass auch hier die Belastung auf die Kante des Glases übertragen wird. Die Schutzfolie eignet sich nicht zum Schutz der Kante durch Aufnahme von auf die Kante wirkenden Zugkräften.

In der EP 2 548 730 A1 ist ein Verbund aus einer Dünnglasfolie mit einem polymeren Trägermaterial offenbart, der auch auf Rolle gewickelt sein kann, wobei das Trägermaterial, seitlich über die Kanten der Glasfolie hinausragt. Auch hier weist das polymere Trägermaterial einen eindeutig geringeren E-Modul als Glas auf und das polymere Trägermaterial ist über seine gesamte Ausdehnung aus einem einheitlichen Material gebildet.

Die US 2013/0196163 A1 offenbart einen auf Rolle gewickelten Verbund einer Dünnglasfolie mit einer Verstärkungsschicht, wobei die Dicke der Verstärkungsschicht so gewählt wird, dass bei einer Biegung des Verbundes zur Glasseite hin die neutrale Faser nicht innerhalb des Glases zu liegen kommt. Dies sei gegeben, wenn die Dicke der Verstärkungsschicht größer als die Dicke der Dünnglasfolie multipliziert mit der Wurzel des Quotienten aus E-Modul des Glases geteilt durch den E-Modul der Verstärkungsschicht ist. Nachteilig ist, dass durch die hohe Zugsteifigkeit der gesamten Verstärkungsschicht ein sehr biegesteifer Verbund entsteht, also die Flexibilität des Verbundmaterials gegenüber der reinen Dünnglasfolie deutlich vermindert wird.

Es ist Aufgabe der Erfindung, eine Dünnglasfolienverbundbahn zur Verfügung zu stellen, die einen verbesserten Schutz der Kante der Dünnglasfolie ermöglicht und dennoch die Biegesteifigkeit nicht zu sehr erhöht.

Es ist auch Aufgabe der Erfindung, ein Verfahren zur Lagerung einer Dünnglasfolienbahn zur Verfügung zu stellen.

Die Aufgabe wird in ihrem ersten Aspekt durch eine eingangs genannte Dünnglasfolienverbundbahn gelöst, die die kennzeichnenden Merkmale des Anspruchs 1 aufweist.
Die Aufgabe wird in ihrem zweiten Aspekt durch ein Verfahren mit den Merkmalen des Anspruchs 17 erfüllt.

Die erfindungsgemäße Dünnglasfolienverbundbahn weist eine Dünnglasfolienbahn auf mit einer ersten und zweiten Oberfläche und zwei in einer Längsrichtung der Dünnglasfolienbahn verlaufenden Dünnglasfolienkanten. Die Dünnglasfolienverbundbahn weist auch eine Schutzfolienbahn aus einem ersten Material auf, die sich zumindest entlang eines Teils der ersten Oberfläche der Dünnglasfolie erstreckt. Erfindungsgemäß ist entlang zumindest einer der beiden Dünnglasfolienkanten verlaufend zumindest ein Versteifungsstreifen aus einem zweiten Material vorgesehen, das vom ersten Material verschieden ist, wobei die Schutzfolienbahn und der zumindest eine Versteifungsstreifen derart miteinander verbunden sind, dass sie gemeinsam auf die Dünnglasbahn applizierbar sind. Der zumindest eine Versteifungsstreifen weist zudem eine höhere relative Zugsteifigkeit auf als die Dünnglasfolienbahn.

Zunächst ist unter einer Folienbahn ein flächenförmiges Gebilde zu verstehen, dessen Abmessungen in einer Raumrichtung, nämlich Höhe oder Dicke, signifikant kleiner sind als in den beiden anderen Raumrichtungen. Die Hauptausdehnung definieren Länge und Breite. Bei einer Folienbahn sind darüber hinaus Breite und Dicke festgelegt. Die Länge der Folienbahn ist in der Regel aber nicht fest definiert. Die Länge der Folienbahn beträgt in der Regel zumindest das Zehnfache der Breite. Die Folienbahn kann einfach zusammenhängend oder auch durchbrochen ausgebildet sein. Sie kann aus einem einzigen Material oder bereichsweise unterschiedlichen Materialien bestehen, die Folienbahn kann über ihre gesamte Flächenausdehnung eine konstante Dicke oder aber auch unterschiedliche Dicken aufweisen. Die Folienbahn kann aus einer einzigen Schicht oder mehreren Schichten bestehen, die deckungsgleich, oder aber zumindest teilweise nicht überdeckend angeordnet sind.

Unter einer Dünnglasfolienbahn wird eine Folie mit einer Höhe von 10 bis 200 µm, vorzugsweise 20 bis 100 µm, vorzugsweise 25 bis 75 µm, besonders bevorzugt 30 bis 50 µm verstanden. Vorzugsweise ist die gesamte Dünnglasfolienbahn aus Dünnglas gebildet. Dünnglasfolien sind sehr gut als permeationssperrende Substrate geeignet. Dünngläser sind beispielsweise als D263 der Firma Schott oder als Willow® Glass der Firma Corning verfügbar.

Vorteilhafterweise wird ein Borosilikatglas wie das D263 T eco der Firma Schott, ein Alkali-Erdalkali-Silikatglas oder ein Aluminiumborosilikatglas wie AF 32 eco, ebenfalls von der Firma Schott, für die erfindungsgemäße Dünnglasfolienverbundbahn verwendet. Ein alkalifreies Dünnglas wie AF 32 eco ist vorteilhaft, weil die UV-Transmission höher ist. Für UV-härtende Klebstoffsysteme können daher Initiatoren mit Absorptionsmaxima im UV-C-Bereich besser verwendet werden, was die Stabilität der unvernetzten Klebemassen gegenüber Tageslicht erhöht.

Ein alkalihaltiges Dünnglas wie D263 T eco ist vorteilhaft, weil der Wärmeausdehnungskoeffizient höher ist und besser mit den polymeren Bestandteilen einer organischen elektronischen Anordnung, zum Beispiel eines OLED-Aufbaus, zusammenpasst.

Derartige Dünngläser können im Down-Draw-Prozess, wie er in der WO 00/41978 A1 referenziert ist, oder in Verfahren hergestellt werden, wie sie beispielsweise in der EP 1 832 558 A1 offenbart sind. In der erstgenannten Druckschrift sind weitere Verfahren offenbart, Verbunde aus Dünnglas und Polymerschichten oder -folien herzustellen. Bei Dünnglasfolien oder Dünnglasfolienbahnen ist aufgrund der intrinsisch hohen Barriereeigenschaft des Glases gegenüber Sauerstoff und Wasserstoff eine weitere sperrende Beschichtung nicht erforderlich.

Die Schutzfolienbahn aus einem ersten Material erstreckt sich entlang zumindest eines Teils der ersten Oberfläche der Dünnglasfolienbahn. Die Schutzfolienbahn deckt die erste Oberfläche vorzugsweise vollflächig oder zumindest bereichsweise, vorzugsweise zumindest entlang eines Streifens an jeder der beiden Kanten der Dünnglasfolienbahn ab.

Bevorzugt ist die erste Oberfläche der Dünnglasfolienbahn vollflächig abgedeckt, weil dadurch die gesamte Oberfläche der Dünnglasfolienbahn durch die Schutzfolienbahn vor zum Beispiel mechanischen, chemischen oder physikalischen Beschädigungen geschützt ist.

Als Material der Schutzfolienbahn der erfindungsgemäßen Dünnglasfolienverbundbahn können textile Flächengebilde, Papiere, kunststoffbeschichtete Papiere oder Folien eingesetzt werden, wobei Folien insbesondere dimensionsstabile Kunststoff- oder Metallfolien sind. Beispielhaft aber nicht einschränkend erwähnt seien Metallfolien aus Aluminium oder Kunststofffolien aus Polyolefinen wie Polyethylen (PE) oder Polypropylen (PP), Cyclischen Olefin Copolymeren (COC), Polyvinylchlorid (PVC), Polyester - insbesondere Polyethylenterephthalat (PET) und Poylethylennaphtalat (PEN), Polymethylpenten (PMP), Ethylenvinylalkohol (EVOH), Polyvinylidenchlorid (PVDC), Fluorpolymeren wie Polyvinylidenfluorid (PVDF), Polyacrylnitril (PAN), Polycarbonat (PC), Polyamid (PA), Polyethersulfon (PES), Polyetherimid (PEI), Polyarylat (PAR), Cellulosetriacetat (TAC), Polymethacrylat (PMMA) oder Polyimid (PI).

Die Schutzfolienbahn besteht bevorzugt aus Polyestern, insbesondere aus Polyethylenterephthalat, zum Beispiel aus biaxial verstrecktem Polyethylenterephthalat, oder aus Polyolefinen, insbesondere aus Polybuten, Cyclo-Olefin-Copolymer, Polymethylpenten, Polypropylen oder Polyethylen, zum Beispiel aus monoaxial verstrecktem Polypropylen, biaxial verstrecktem Polypropylen oder biaxial verstrecktem Polyethylen oder deren Copolymeren. Polyesterfolien weisen den Vorteil auf, dass sie für Temperaturstabilität sorgen und eine erhöhte mechanische Stabilität einbringen. Ganz besonders bevorzugt besteht daher die Schutzfolienbahn aus einer Polyesterfolie, beispielsweise aus biaxial verstrecktem Polyethylenterephthalat. Polyolefine weisen den Vorteil der geringen Wasserdampfpermeationsrate und eines geringeren Wassergehalts auf. Ganz besonders bevorzugt besteht daher die Schutzfolienbahn aus einer Folie umfassend Cyclo-Olefin-Copolymer oder Polymethylpenten, die auch eine höhere Temperaturstabilität aufweisen als andere Polyolefinfolien.

Die Schutzfolienbahn kann auch aus Verbunden, insbesondere aus schichtförmigen Verbunden, der genannten Materialien miteinander oder mit anderen Materialien bestehen.

In einer bevorzugten Ausführungsform enthält die Schutzfolienbahn eine Barrierefunktion. Die Barrierefunktion hindert ein oder mehrere spezifische(s) Permeat(e), insbesondere Wasserdampf, daran, in den Dünnglasfolienverbund einzudringen und Spannungsrisskorrosion in der Dünnglasbahn zu promovieren.

Vorzugsweise ist die Barrierefunktion durch eine Barriereschicht ausgebildet. Die Barriereschicht ist günstigerweise auf einer Oberfläche der Schutzfolienbahn ausgebildet, kann aber auch als Schicht in dieser enthalten sein.

Eine derartige Barriereschicht kann aus organischen oder anorganischen Materialien bestehen, beispielsweise aus einer Metallschicht oder einer organischen Schicht oder einer Sol-Gel Schicht.

Die Barriereschicht ist vorzugsweise an einer Innenseite, an der der Glasfolie zugewandten Seite der Schutzfolienbahn vorgesehen, da damit die Barriereschicht vor mechanischer Beschädigung besser geschützt ist.

Besonders bevorzugt enthält die Schutzfolienbahn mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Schutzfolie verwirklichen lassen. Bevorzugt wird eine Permeationsbarriere der Schutzfolienbahn mit Barrierefunktion beziehungsweise des Verbundes aus Schutzfolienbahn und Barriereschicht gegen Wasserdampf (WVTR) von < 1 g/(m^{2∗}d) und/oder gegen Sauerstoff (OTR) von < 1 cm³/(m^{2∗}d^{∗}bar), wobei der Wert auf die jeweils verwendete Dicke der Schutzfolienbahn mit Barrierefunktion bezogen ist, also nicht auf eine spezifische Dicke normiert ist. Die WVTR wird dabei bei 38 °C und 90 % relativer Luftfeuchtigkeit nach ASTM F-1249 und die OTR bei 23 °C und 50 % relativer Luftfeuchtigkeit nach DIN 53380-Teil 3 gemessen.

Die Versteifungsstreifen aus einem zweiten vom ersten Material verschiedenen Material sind entlang jeder oder zumindest einer der beiden Kanten der Dünnglasfolienbahn entlang deren vorzugsweise gesamten Längsausdehnung in Längsrichtung angeordnet. Die Versteifungsstreifen verlaufen im Wesentlichen parallel, vorzugsweise exakt parallel zur Kante der Dünnglasfolienbahn. Dabei verlaufen die Versteifungsstreifen parallel zur idealen Kante der Dünnglasfolienbahn, da die reale Kante der Dünnglasfolienbahn Toleranzen in ihrer Geradheit, zum Beispiel Säbeligkeit oder Kantenwelligkeit, aufweist. Die Versteifungsstreifen sind in ihrer Breite und Dicke beziehungsweise Höhe festgelegt. Seine Länge ist in der Regel nicht fest definiert, sondern orientiert sich an der Länge der Dünnglasfolienbahn. Vorzugsweise ist die Länge der Versteifungsstreifen gleich der Länge der Dünnglasfolienbahn.

Günstigerweise sind die Breite und Höhe der Versteifungsstreifen über die gesamte Länge der Versteifungsstreifen konstant, das heißt, der Querschnitt bleibt über die gesamte Länge gleich. Es ist jedoch auch denkbar, dass Höhe und/oder Breite über die Länge variabel ausgestaltet sind.

Die Versteifungsstreifen können entlang der gesamten Länge entlang der Kante der Dünnglasfolienbahn geführt sein. Die Versteifungsstreifen können jedoch auch entlang ihrer Länge unterbrochen sein, beispielsweise wenn die Dünnglasfolienbahn in Längsrichtung aus einzelnen Abschnitten besteht, wobei dann die Versteifungsstreifen nur entlang der Kante der Dünnglasfolienbahn geführt sind.

Erfindungsgemäß verlaufen die Versteifungsstreifen der Schutzfolie nur im Bereich der Kante der Dünnglasfolie, das heißt, die Versteifungsstreifen erstrecken sich in ihrer Breite nicht über die gesamte Breite der Dünnglasfolienbahn und/oder der Schutzfolienbahn. Vorzugsweise beträgt die Summe der Breiten der Versteifungsstreifen entlang einer Kante der Dünnglasfolienbahn weniger als die Hälfte der Gesamtbreite der Dünnglasfolienbahn, vorzugsweise weniger als ein Drittel, vorzugsweise weniger als ein Viertel der Gesamtbreite der Dünnglasfolienbahn.

Dass der zumindest eine Versteifungsstreifen zumindest entlang einer der beiden Kanten verläuft, meint, dass die Projektion des Versteifungsstreifens senkrecht zur Oberfläche der Dünnglasfolienbahn in deren Ebene zumindest teilweise außerhalb der Fläche der Dünnglasfolienbahn zu liegen kommt. Teilweise außerhalb umfasst dabei auch eine Berührung der Kante der Projektion des Versteifungsstreifens mit der Kante der Dünnglasfolienbahn. Bevorzugt liegt die Projektion des Versteifungsstreifens zumindest mit der Hälfte ihrer Fläche, besonders bevorzugt vollständig außerhalb der Fläche der Dünnglasfolienbahn.

Dies bedeutet anschaulicher, dass ein Versteifungsstreifen in der Projektion die Glaskante überdeckt oder egalisiert (also genau an der Kante liegt) oder aber außerhalb der Dünnglasfolienbahn neben der Glaskante liegt. Dabei kann die Projektion des Versteifungsstreifens auch einen äußeren Abstand zur Kante der Dünnglasfolienbahn aufweisen. Erfindungsgemäße und nicht erfindungsgemäße Anordnungen sind in den Figuren dargestellt.

Die Versteifungsstreifen können verschiedene äußere Abmessungen, insbesondere in Breite und Höhe und in ihrer Anordnung hinsichtlich der Kante der Dünnglasfolienbahn aufweisen.

Vorzugsweise sind die Versteifungsstreifen beabstandet zur Dünnglasfolienkante angeordnet, günstigerweise sind die Versteifungsstreifen entlang der gesamten Länge beabstandet zur Dünnglasfolienkante angeordnet. Durch den Abstand werden Toleranzen in der Gradheit der Dünnglasfolienbahn und der Versteifungsstreifen abgepuffert, insbesondere Säbeligkeit und Welligkeit der Kante der Dünnglasfolienbahn. Innerhalb einer Abstandszone zwischen den Versteifungsstreifen und der Dünnglasfolienbahn entsteht ein Bereich, der lediglich aus dem Teilbereich der Schutzfolienbahn gebildet ist, der weder durch einen Versteifungsstreifen noch durch die Dünnglasbahn selbst versteift ist, und der im Vergleich zu den Versteifungsstreifen und zur Dünnglasfolienbahn in der Regel eine höhere Flexibilität aufweist. Dadurch können Kraftspitzen und Bahnversatz elastisch abgepuffert werden und einseitige Beanspruchungen der Dünnglasfolienverbundbahn etwa durch eine Bahnkantensteuerung sanft in die Dünnglasfolienbahn eingeleitet werden, ohne dass die Dünnglasfolienkante übermäßig beansprucht wird. Der Abstand d ist an seiner unteren Grenze durch übliche Toleranzen in der Geradheit der Dünnglasbahn begrenzt. Diese betragen etwa von 0,5 mm bis zu 10 mm. An seiner oberen Grenze ist der Abstand nicht prinzipiell begrenzt, jedoch wird ein Abstand von 10 bis 50 mm bevorzugt, da bei größerem Abstand in den Versteifungsstreifen eingeleitete Bahnführungskräfte zu einer Faltenbildung in dem frei liegenden Bereich der Schutzfolienbahn führen können.

Vorzugsweise sind die Versteifungsstreifen vollständig in einem durch die gedachte seitliche Verlängerung der ersten und zweiten Oberfläche der Dünnglasfolienbahn aufgespannten Raum, der Dünnglasfolienebene, angeordnet.

Günstigerweise sind die erste und zweite Oberfläche der Dünnglasfolienbahn planar ausgebildet und bilden jeweils eine Ebene aus. Die gedachten seitlichen Verlängerungen der Ebenen über die jeweilige Kante der Dünnglasfolienbahn hinaus eröffnen einen Raum, in dem die Dünnglasfolie angeordnet ist, dessen Höhe der Höhe der Dünnglasfolie entspricht, der in seiner Breite in der Regel nicht beschränkt ist, es sei denn, die beiden Oberflächen sind in einem Winkel zueinander geneigt und schneiden sich entlang einer seitlichen Linie, und dessen Länge der Länge der Dünnglasfolienverbundbahn entspricht. Dieser Raum wird hier auch die Dünnglasfolienebene genannt. Entsprechend besteht eine Schutzfolienebene, in der die Schutzfolienbahn angeordnet ist.

Günstigerweise sind die Versteifungsstreifen vollständig in der Dünnglasfolienebene angeordnet, das heißt, ein der Schutzfolienbahn abgewandtes äußerstes Ende oder eine freie Ebene der Versteifungsstreifen weisen eine Höhe über der Schutzfolienbahn auf, die gleich oder geringer ist als die Höhe der zweiten Oberfläche der Dünnglasfolienbahn über der Schutzfolienbahn.

In einer weiteren bevorzugten Ausführungsform der Erfindung fluchtet eine obere, freie Seite der Versteifungsstreifen mit der zweiten Oberfläche der Dünnglasfolienbahn. Dadurch kann die Dünnglasfolienverbundbahn ohne Versatz entlang der Breite aufgewickelt werden.

In einer anderen Ausführungsform ist die Höhe der Versteifungsstreifen größer als die Höhe der Dünnglasfolienbahn über der Schutzfolienbahn. Dadurch werden besonders biegesteife Versteifungsstreifen zur Verfügung gestellt. Bevorzugt ist aber, dass die Höhe des Versteifungsstreifens nicht größer ist als die fünffache Dicke der Dünnglasfolienbahn, insbesondere nicht größer als die dreifache Dicke, da sonst die Biegesteifigkeit zu groß wird und sich der Dünnglasfolienverbund nur schwer zu einer Rolle wickeln lässt.

Die Versteifungsstreifen können eine gleich große Querschnittsfläche und damit eine gleiche Zugsteifigkeit und dennoch eine unterschiedliche Höhe aufweisen. Die Versteifungsstreifen mit der größeren Höhe weisen dann die größere Biegesteifigkeit auf.

In einer weiteren bevorzugten Ausführungsform der Erfindung ist die Höhe der Versteifungsstreifen jedoch geringer als die Höhe der Dünnglasfolienbahn, so dass bei dieser Ausführungsform eine geringe Biegesteifigkeit erzielt wird, so dass die Dünnglasfolienverbundbahn besonders flexibel bleibt und damit günstigerweise mit geringen Kräften auf eine Rolle gewickelt werden kann.

In bevorzugten Ausführungsformen der Erfindung ist zwischen der Dünnglasfolienbahn und der Schutzfolienbahn eine Klebstoffschicht, insbesondere eine Haftklebstoffschicht vorgesehen. Die Schutzfolienbahn kann die Klebstoffschicht umfassen, diese kann aber auch separat auf die Dünnglasfolie oder die Schutzfolie aufgebracht sein. Die Haftung kann zum einen durch das Schutzfilmmaterial selbst oder durch eine Schicht eines Klebstoffs, bevorzugt eines Haftklebstoffs oder eines aktivierbaren Klebstoffs hergestellt sein.

Die Schutzfilmbahn kann aus einer fluiden Phase auf die Dünnglasfolienbahn beschichtet werden oder als vorgefertigte Schicht, beispielsweise als Folie, auf die Dünnglasfolienbahn aufgebracht werden. Günstigerweise ist die Schutzfolienbahn ein Klebeband mit zumindest einer Trägermaterialschicht und zumindest einer Klebstoffschicht und ist mit zumindest einem Versteifungsstreifen verbunden.

Die Schutzfolienbahn und der zumindest eine Versteifungsstreifen sind erfindungsgemäß derart miteinander verbunden, dass sie gemeinsam auf die Dünnglasbahn applizierbar sind. Gemeinsam applizierbar heißt, dass zunächst ein Verbund aus Schutzfolienbahn und Versteifungsstreifen gebildet werden kann und dann dieser Verbund in Kontakt mit der Dünnglasfolienbahn gebracht werden kann.

Die Versteifungsstreifen können durch das Einbringen versteifenden Materials in eine Schutzfolienbahn, insbesondere in deren Trägermaterialschicht, entstehen, zum Beispiel durch Verfahren wie Co-Extrusion oder Pultrusion. Bei dem versteifenden Material kann es sich beispielsweise um Metall- oder Kohlenstofffasern, Kohlenstoffnanoröhrchen, Graphen, kristalline oder amorphe Mineralfasern handeln. Vorzugsweise haben die eingebrachten Versteifungsmaterialien einen höheren E-Modul als das Dünnglas, insbesondere einen E-Modul, der zumindest um den Faktor 1,5 höher als der des Dünnglases ist. Dadurch sind in der Höhe dünne Versteifungsstreifen möglich, die die Biegeflexibilität des Verbundes insgesamt weniger beeinträchtigen.

Die Versteifungsstreifen können als weitere Schicht auf die Schutzfolienbahn aufgebracht und mit dieser verbunden sein. Sie können jedoch auch in Abschnitte der Schutzfolienbahn eingebracht sein und damit innerhalb der Schutzfolienbahn eine weitere Bahn ausbilden.

Die Herstellung des Verbundes der Schutzfolienbahn mit dem zumindest einen Versteifungsstreifen erfolgt bevorzugt vor dem Applizieren der Schutzfolienbahn auf die Dünnglasfolienbahn, sie kann aber auch danach erfolgen.

Dass die Schutzfolienbahn aus dem ersten Material besteht und die Versteifungsstreifen aus dem zweiten Material bestehen, bedeutet hier, dass die chemische oder physikalische Zusammensetzung der beiden Bahnen unterschiedlich ist. Dieser Unterschied kann auch darauf beruhen, dass in das erste Material weitere Komponenten physikalisch eingebracht sind und damit dieser Bereich, in den die Komponenten eingebracht sind, insgesamt ein zweites Material ausbildet. Das zweite Material kann beispielsweise das erste Material chemisch vollständig enthalten. Dennoch weisen die beiden Materialien insgesamt unterschiedliche E-Module auf. Die Versteifungsstreifen weist erfindungsgemäß eine relative Zugsteifigkeit auf, die zumindest der relativen Zugsteifigkeit der Glasfolienbahn entspricht. Unter Zugsteifigkeit wird dabei der E-Modul multipliziert mit der Querschnittsfläche A der Versteifungsstreifen beziehungsweise der Glasfolienbahn verstanden. Die relative Zugsteifigkeit wird auf die Breite der jeweiligen Bahn beziehungsweise des Streifens bezogen und ist dementsprechend die Zugsteifigkeit geteilt durch die Breite B. Ist der Querschnitt des Versteifungsstreifens nicht rechteckig, wird als Breite die maximale Breite gewählt.

Die Versteifungsstreifen können durchaus mehrschichtig oder-lagig aufgebaut sein. Wenn die Versteifungsstreifen aus mehreren Schichten bestehen, so ist die gesamte Zugsteifigkeit die Summe der Zugsteifigkeiten der einzelnen Schichten.

Der E-Modul von Dünnglas beträgt etwa 70 bis 80 GPa, das heißt, um die erfindungsgemäße relative Zugsteifigkeit in den Versteifungsstreifen zu erreichen, kann die Dicke der Versteifungsstreifen gegenüber der der Glasfolie erhöht werden, oder der E-Modul des zweiten Materials wird erhöht. Da günstigerweise die Dicke der Versteifungsstreifen die Dicke der Dünnglasfolie nicht überschreiten soll, da anderenfalls beim Aufrollen der Dünnglasfolienverbundbahn die Dünnglasfolien nicht vollflächig auf den radial benachbarten inneren Wickeln der Rolle aufliegen und es zu Spannungen in der Rolle kommen kann, ist vorzugsweise vorgesehen, den E-Modul der Versteifungsstreifen größer zu wählen als den E-Modul des Dünnglases.

Als Material der Versteifungsstreifen werden vorzugsweise Materialien mit einem E-Modul bei 23 °C und relativer Luftfeuchtigkeit von 50 % von mehr als 80 GPa, insbesondere mehr als 100 GPa eingesetzt, da hiermit die Dicke der Versteifungsstreifen gering gehalten werden kann und somit die Biegeflexibilität des Gesamtverbundes der Dünnglasfolienverbundbahn weniger beeinträchtigt wird. Die Versteifungsmaterialien können als durchgehende Schicht, faserförmig oder plättchenförmig vorliegen. Sie können in den Versteifungsstreifen im Wesentlichen als Reinmaterial oder eingebettet in ein Matrixmaterial, zum Beispiel ein Polymer, ein Metall oder eine Keramik, vorliegen. Neben Metallen sind bekannte Materialien zum Beispiel S-Glasfasern, Kohlenstofffasern, Aramidfasern (zum Beispiel Kevlar 49), Kohlenstoffnanoröhrchen, Graphen sowie kristalline oder amorphe Mineralfasern (zum Beispiel Saffil Aluminiumoxidfasern). Als Material der Versteifungsstreifen wird bevorzugt eine Metallschicht, zum Beispiel in Form einer Metallfolie oder in Form von Metallfasern, eingesetzt. Aufgrund ihres hohen E-Moduls sind Eisen, Stahl, Kupfer, Messing, Bronze, Titan, Nickel und deren Legierungen bevorzugt. Nachfolgend sind die E-Moduli einiger Fasern dargestellt, insbesondere können S-Glass, Alumina, Carbon und Kevlar 49 als Material der Versteifungsstreifen gewählt werden.

| Material | Dichte (g/cm³) | Zugfestigkeit (MPa) | E-Modul (GPa) |
|---|---|---|---|
| E-Glass | 2.55 | 2000 | 80 |
| S-Glass | 2.49 | 4750 | 89 |
| Alumina (Saffil) | 3.28 | 1950 | 297 |
| Carbon | 2.00 | 2900 | 525 |
| Kevlar 29 | 1.44 | 2860 | 64 |
| Kevlar 49 | 1.44 | 3750 | 136 |

Die relative Zugsteifigkeit des Versteifungsstreifens ist größer als die relative Zugsteifigkeit der Schutzfolienbahn.

Die Schutzfolienbahn wird vorzugsweise mit einer Klebemasse auf die Dünnglasfolienbahn aufgeklebt.

Vorzugsweise ist das auf die Schutzfolienbahn aufgebrachte Klebemittel eine Haftklebemasse oder eine aktivierbare Klebemasse, insbesondere eine reversible und/oder transparente Klebemasse. Besonders bevorzugt ist die auf der Trägermaterialschicht aufliegende Klebemasse eine Haftklebemasse.

Als Haftklebemassen werden Klebemassen bezeichnet, deren abgebundener Film bei Raumtemperatur im trockenen Zustand permanent klebrig und klebfähig bleibt. Haftklebemassen erlauben bereits unter relativ schwachem Andruck eine dauerhafte Verbindung mit dem Haftgrund.

Allgemein wird zwischen Haftklebemassen für permanente Anwendungen und für reversible Anwendungen (reversibel eingestellte Haftklebemassen) unterschieden. Während sich erstere in der Regel nur mit hohem Kraftaufwand und oft unter Zerstörung des Untergrunds oder des Klebebands selbst wieder ablösen lassen, können letztere mit relativ geringem Kraftaufwand und ohne Zerstörung des Haftgrunds in der Regel vollständig rückstandsfrei wieder abgelöst werden.

Erfindungsgemäß bevorzugt ist die auf der Schutzfolienbahn aufliegende Klebemasse des im erfindungsgemäßen Verfahren eingesetzten Klebebands reversibel eingestellt.

Die Reversibilität einer Haftklebemasse kann mittels ihrer viskoelastischen Eigenschaften beschrieben werden.

Ein Stoff wird bezüglich seiner viskoelastischen Eigenschaften im Allgemeinen als für Haftklebeanwendungen geeignet angesehen, wenn bei Raumtemperatur im Frequenzbereich von 10° bis 10¹ rad/s, idealerweise im Frequenzbereich von 10⁻¹ bis 10² rad/s, das Speichermodul G' im Bereich von 10³ bis 10⁶ Pa liegt und wenn das Verlustmodul G" ebenfalls in diesem Bereich liegt. Innerhalb dieses Bereiches, den man in einer Matrix-Auftragung aus G' und G" (G' aufgetragen in Abhängigkeit von G") auch als viskoelastisches Fenster für Haftklebeanwendungen oder als Haftklebstofffenster nach viskoelastischen Kriterien bezeichnen kann, gibt es wiederum unterschiedliche Sektoren beziehungsweise Quadranten, die die zu erwartenden Haftklebeeigenschaften der jeweils zugehörigen Stoffe näher charakterisieren. Nach Chang (J. Adhesion, 1991, vol. 34, Seiten 189 bis 200) sind reversible Haftklebemassen durch G' im Bereich von 10³ bis 3x10⁴ Pa und G" im Bereich von 10³ bis 3x10⁴ Pa jeweils bei Raumtemperatur und einer Messfrequenz von 10⁻² rad/s charakterisiert.

Speichermodul und Verlustmodul für Haftklebemassen werden hierbei im oszillatorischen Scherexperiment (Dynamisch mechanische Analyse, DMA) unter Torsionsbelastung bei einer Temperatur von 23 °C und einer Frequenz von 0,01 rad/s bestimmt. Der Test dient der Untersuchung rheologischer Eigenschaften und ist in Pahl et al. "Praktische Rheologie der Kunststoffe und Elastomere", VDI-Verlag, 1995, Seite 57 bis 60 sowie 119 bis 127) ausführlich beschrieben. Der Test wird in einem schergeschwindigkeitskontrollierten Rheometer unter Torsionsbelastung gefahren, wobei eine Platte-Platte-Geometrie mit einem Plattendurchmesser von 25 mm verwendet wird.

Erfindungsgemäß bevorzugt wird eine Klebemasse allgemein dann als reversibel eingestellt angesehen, wenn sie eine Klebkraft auf Stahl von < 3 N/cm, bevorzugt von < 2,2 N/cm aufweist.

Erfindungsgemäß können alle dem Fachmann bekannten Haftklebemassen verwendet werden, also beispielsweise solche auf der Basis von Acrylaten und/oder Methacrylaten, Polyurethanen, Naturkautschuken, Synthesekautschuken; Styrolblockcopolymermassen mit einem Elastomerblock aus ungesättigten oder hydrierten Polydienblöcken wie zum Beispiel Polybutadien, Polyisopren, Copolymeren aus beiden, Polybutylen, insbesondere Polyisobutylen, sowie weiteren, dem Fachmann geläufigen Elastomerblöcken; Polyolefinen, insbesondere Poly-α-olefinen und/oder Polyisobutylenen; Fluorpolymeren und/oder Silikonen. Unter den Begriff "Haftklebemasse" fallen auch weitere Massen, die haftklebende Eigenschaften entsprechend dem "Handbook of Pressure Sensitive Adhesive Technology" von Donatas Satas (Satas & Associates, Warwick 1999) besitzen.

Werden im Rahmen dieser Schrift Haftklebemassen auf Acrylbasis erwähnt, so sollen hiervon auch ohne explizite Erwähnung Haftklebemassen auf Basis von Methacrylaten und auf Basis von Acrylaten und Methacrylaten umfasst sein, sofern nicht ausdrücklich anders beschrieben.

Als aktivierbare Klebemassen werden Klebemassensysteme angesehen, bei denen die Herstellung einer Klebkraft überhaupt beziehungsweise die Erhöhung oder Erniedrigung der Klebkraft durch einen Energieeintrag, zum Beispiel durch aktinische Strahlung oder Wärme, oder eine stoffliche Wechselwirkung erfolgt. Die Aktivierung wird bevorzugt dazu verwendet, eine Reversibilität der Verklebung herzustellen, insbesondere dann, wenn eine Haftklebemasse vor ihrer Aktivierung nicht den reversiblen Haftklebemassen (Chang, J. Adhesion, 1991, vol. 34, Seiten 189 bis 200) zuzuordnen ist. Solche aktivierbaren Haftklebemassen sind beispielsweise aus dem Bereich der Grinding- und Dicing-Klebebänder, welche in der Waferbearbeitung eingesetzt werden, bekannt.

Als aktivierbare Klebemassen können grundsätzlich alle üblichen aktiviert verklebenden Klebemassensysteme zum Einsatz gelangen. Die Aktivierung erfolgt erfindungsgemäß bevorzugt in der Regel über einen Energieeintrag, zum Beispiel und besonders bevorzugt durch aktinische Strahlung oder Wärme (hitzeaktiviert entklebende Klebemassen).

Erfindungsgemäß werden auch sogenannte "autoadhäsive" Schichten als reversibel eingestellte Haftklebemassen angesehen. Autoadhäsive Schichten kommen zum Beispiel in Displayschutzfolien zum Einsatz. Sie zeigen nur sehr geringe oder gar keine Anfassklebrigkeit, sie haften jedoch insbesondere auf sehr glatten Flächen. Autoadhäsive Schichten sind beispielsweise in der WO 2005/044560 A1 oder der DE 197 42 805 A1 beschrieben.

Vorzugsweise enthält die Klebemasse zumindest ein Silan. Silane werden häufig als Kopplungsagentien eingesetzt, um die Klebkraft auf Glas zu erhöhen. Beispiele sind in der US 6,195,608, WO 2008/036222 A1, JP 2000-003782 A1, US 6,501,014 B1, WO 2011/084323 A1 und EP 0 924 761 A1 aufgeführt. Das Silan wird nicht nur vor der Verklebung als Primer auf die Dünnglasfolienbahn aufgetragen, sondern kann auch in der Klebemasse selbst enthalten sein. Es können Silane eingesetzt werden, die chemische Gruppen enthalten, die mit der Klebemasse gut verträglich sind oder sogar kovalente, ionische oder koordinative Bindungen mit der Klebemasse eingehen können. Wenn die Schutzfolienbahn permanent auf der Dünnglasfolienbahn verbleibt, enthalten deren Klebemassen vorzugsweise ein Silan, das mit der Klebemasse gut verträglich ist. In einer anderen Ausführungsform der Erfindung, bei der die Schutzfolienbahn von der Dünnglasfolienbahn wieder abgezogen wird, werden reversible Klebemassen eingesetzt. Diese können ein mit der Klebemasse unverträgliches Silan enthalten oder ein solches, das keine kovalente, ionische oder koordinative Bindung mit der Klebemasse eingehen kann. Dadurch wird eine Erhöhung der Haftung der reversiblen Klebemasse an der Dünnglasfolienbahn weitgehend vermieden. Durch die Unverträglichkeit des Silans mit der Klebemasse lagern sich die migrierfähigen Silanmoleküle an der Oberfläche der Klebemasse ab und kommen somit in großer Menge mit der Glasfolienbahn in Kontakt. Aufgrund des sich so bildenden Silanfilms auf der zweiten Oberfläche der Dünnglasfolienbahn können Mikrorisse sogar überbrückt und die Glasstabilität verbessert werden. Vorzugsweise enthält die Klebemasse ein hydrophobes Silan, wobei unter hydrophoben Silanen hier Silane mit mehr als acht zusammenhängenden Kohlenstoffatomen definiert werden, beispielsweise Octadecyldimethylchlorosilan.

Des Weiteren betrifft die Erfindung Verfahren zur Lagerung von Dünnglasfolienbahnen, indem
- die Dünnglasfolienbahn mit einer ersten und einer zweiten Oberfläche und zwei in einer Längsrichtung verlaufenden Kanten zur Verfügung gestellt wird,
- eine Schutzfolienbahn aus einem ersten Material entlang zumindest eines Teils der ersten Oberfläche aufgebracht wird,
- zumindest ein Versteifungsstreifen aus einem zweiten Material, das vom ersten Material verschieden ist und das eine höhere relative Zugsteifigkeit aufweist als die Dünnglasfolienbahn entlang zumindest einer der beiden Kanten angeordnet wird,
- wobei Schutzfolienbahn und Versteifungsstreifen derart miteinander verbunden sind, dass sie gemeinsam auf die Dünnglasbahn applizierbar sind.
Vorteilhafte Varianten finden sich in den sich anschließenden Ansprüchen 18 bis 26.

Weiterhin offenbart wird ein Verfahren, bei dem der Bereich der Schutzfolie, der die Versteifungszonen enthält, nach der Ver- oder Bearbeitung der Glasfolie, zum Beispiel in einem Rolle-zu-Rolle-Verfahren, entfernt wird. Andere Bereiche der Schutzfolie verbleiben zumindest temporär auf dem Glas. Bevorzugt verbleiben die anderen Bereiche permanent auf der Glasbahn. So kann die Glasfolie mit einer permanenten Schutzfolie versehen werden, deren Versteifungszonen nur temporär im Verbundmaterial verbleiben. Besonders bevorzugt sind die Versteifungszonen bei diesem Verfahren neben der Glasbahn angeordnet, so dass sie sich einfach durch Schneiden entlang der Bahn abtrennen lassen

Die Erfindung wird anhand von mehreren Ausführungsbeispielen in 18 Figuren beschrieben, dabei zeigen:
Fig. 1 bis Fig. 3 jeweils eine erfindungsgemäße Dünnglasfolienverbundbahn mit Dünnglasfolienbahn und entlang einer ersten Oberfläche vollflächig aufgebrachten Schutzfolienbahnen und zwei seitlichen glasseitigen Versteifungsstreifen,
Fig. 4 eine Dünnglasfolienverbundbahn mit unterbrochener Schutzfolienbahn und zwei seitlichen glasseitigen Versteifungsstreifen,
Fig. 5 bis Fig. 7 jeweils eine Dünnglasfolienverbundbahn mit Schutzfolienbahn und zwei seitlichen glasabseitigen Versteifungsstreifen,
Fig. 8 bis Fig. 13 jeweils eine Dünnglasfolienverbundbahn mit zwei seitlichen, in der Schutzfolienebene angeordneten Versteifungsstreifen,
Fig. 14 bis Fig. 16 jeweils eine Dünnglasfolienverbundbahn mit mehreren Schutzfolienbahnen,
Fig. 17 und 18 jeweils eine Dünnglasfolienverbundbahn mit einer Schutzfolienbahn mit zwei seitlichen glasseitigen Versteifungsstreifen, die mittels einer Klebstoffschicht mit der Glasfolienbahn verbunden ist,
Fig. 19 und 20 jeweils nicht erfindungsgemäße Ausführungen der Dünnglasfolienverbundbahn, bei denen der Versteifungsstreifen nicht entlang zumindest einer der beiden Kanten der Dünnglasfolienbahn verläuft,
Fig. 21 eine weitere Dünnglasfolienverbundbahn mit zwei seitlichen, in der Schutzfolienebene angeordneten Versteifungsstreifen,
Fig. 22 eine Dünnglasfolienverbundbahn mit Schutzfolienbahn und zwei seitlichen Versteifungsstreifen, die sowohl in der Schutzfolienbahnebene und glasseitig wie auch glasabseitig angeordnet sind,
Fig. 23 eine nicht erfindungsgemäße Ausführung der Dünnglasfolienverbundbahn, bei der die Schutzfolienbahn und die Versteifungsstreifen nicht gemeinsam applizierbar sind.

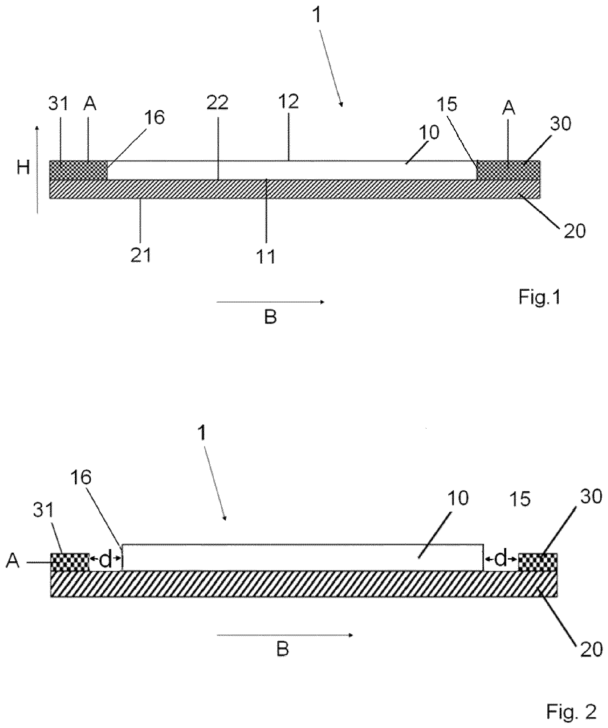

Fig. 1 zeigt einen erfindungsgemäßen Aufbau einer Dünnglasfolienverbundbahn 1 mit einer Dünnglasfolienbahn 10, einer Schutzfolienbahn 20 und zwei seitlichen Versteifungsstreifen 30, 31. Die Dünnglasfolienverbundbahn erstreckt sich in einer Längsrichtung L in großer Länge. In den Figuren ist durchgängig eine senkrecht zur Längsrichtung angeordnete Breite B der Dünnglasfolienverbundbahn 1 dargestellt.

Die Dünnglasfolienbahn 10 weist eine erste Oberfläche 11 und eine zweite Oberfläche 12 auf. Auf die erste Oberfläche 11 ist vollflächig eine zweite Oberfläche 22 der Schutzfolienbahn 20 aufgebracht. Vollflächig meint hier, dass die erste Oberfläche 11 der Dünnglasfolienbahn 10 vollständig von der Schutzfolienbahn 20 abgedeckt wird.

Die Schutzfolienbahn 20 steht entlang der Breite B seitlich auf beiden Seiten über die Dünnglasfolienbahn 10 hinaus ab. Die Dünnglasfolienbahn 10 weist zwei in Längsrichtung L verlaufende seitliche Kanten 15, 16 auf. Die beiden Kanten 15, 16 sind sehr empfindlich, weil Dünnglasfolienbahnen 10 üblicherweise und auch hier nach ihrer Herstellung an den Längsseiten jeweils eine verdickte Borte aufweisen, die zur besseren Handhabung der Dünnglasfolienbahn 10 in Längsrichtung L von der Dünnglasfolienbahn 10 abgeschnitten wird. Die entstehenden abgeschnittenen Kanten 15, 16 der Dünnglasfolienbahn 10 gemäß Fig. 1 sind daher sehr empfindlich und müssen geschützt werden. Insbesondere werden die Dünnglasfolienbahnen 10 auf Rollen aufgewickelt, um transportiert oder gelagert zu werden. Wenn die Dünnglasfolienbahn 10 weiterverarbeitet wird, entstehen durch die Handhabung der Dünnglasfolienbahn 10 insbesondere durch Zugkräfte in Längsrichtung L der Dünnglasfolienbahn 10 Kräfte an den beiden Kanten 15, 16 der Dünnglasfolienbahn 10, die zur Rissbildung führen können. Ein weiterer Aspekt bei der Handhabung der Dünnglasfolienbahn 10 sind Berührungen an den Kanten, die ebenfalls zur Rissbildung führen können.

In der Ausführungsform gemäß Fig. 1 ist in der Ebene der Dünnglasfolienbahn 10 entlang beider Kanten 15, 16 entlang der gesamten Längsrichtung L der Kanten 15, 16 jeweils einer der Versteifungsstreifen 30, 31 auf die zweite Oberfläche 22 der Schutzfolienbahn 20 aufgebracht. Die Versteifungsstreifen 30, 31 liegen jeweils unter direktem Kontakt an der Kante 15, 16 der Dünnglasfolienbahn 10 auf beiden Seiten an. Die Versteifungsstreifen 30, 31 weisen eine Höhe H über der Schutzfolienbahn 20 auf, die genau der Höhe H der Dünnglasfolienbahn 10 entspricht. Sowohl die beiden Versteifungsstreifen 30, 31 als auch die Dünnglasfolienbahn 10 weisen im Querschnitt die über die gesamte Breite B konstante Höhe H auf. Die Höhe H ist auch entlang der Längsrichtung L gleichbleibend. Jeder der Versteifungsstreifen 30, 31 besteht aus einem der oben beschriebenen Materialien mit einem E-Modul, der größer ist als der E-Modul der Dünnglasfolienbahn 10. Dadurch haben die Versteifungsstreifen 30, 31 eine höhere relative Zugsteifigkeit in Längsrichtung L, und Zugkräfte, die in Längsrichtung L auf die Dünnglasfolienverbundbahn der Fig. 1 wirken, gelangen kaum mehr in die Kanten 15, 16 der Dünnglasfolienbahn 10, sondern werden von dem jeweiligen Versteifungsstreifen 30, 31 aufgenommen. Die Dünnglasfolienverbundbahn 1 gemäß Fig. 1 eignet sich insbesondere zum Lagern der Dünnglasfolienbahn 10 einer Rolle, weil die Dünnglasfolienbahn 10 vollflächig auf der Schutzfolienbahn 20 des radial benachbarten inneren Wickels aufliegt.

Fig. 2 zeigt eine Ausführungsform der erfindungsgemäßen Dünnglasfolienverbundbahn 1, bei der die beiden Versteifungsstreifen 30, 31 um einen Abstand d beabstandet von den Kanten 15, 16 der Dünnglasfolienbahn 10 auf einer der Dünnglasfolienbahn 10 zugewandten ersten Oberfläche 21 der Schutzfolienbahn 20 aufgebracht sind. Der Querschnitt der Versteifungsstreifen 30, 31 der Ausführungsformen der Dünnglasfolienverbundbahn 1 in den Fig. 2 und 1 ist gleich groß. Dadurch ist auch die Zugsteifigkeit, die sich aus dem Produkt des E-Moduls und einer Querschnittsfläche A des jeweiligen Versteifungsstreifens 30, 31 ergibt, identisch. Jedoch weist die Form der Querschnittsfläche A der Versteifungsstreifen 30, 31 in Fig. 2 eine andere Gestalt auf als in Fig. 1 auf. Die Versteifungsstreifen 30, 31 in Fig. 2 weisen eine größere Höhe H und eine geringere Breite B als die Versteifungsstreifen 30, 31 in Fig. 1 auf, und die Versteifungsstreifen 30, 31 der Fig. 2 sind insbesondere höher als die Dünnglasfolienbahn 10. Beim Aufwickeln der Dünnglasfolienverbundbahn 1 gemäß Fig. 2 ergibt sich eine größere Biegesteifigkeit gegenüber der Dünnglasfolienverbundbahn 1 gemäß Fig. 1, weil die Versteifungsstreifen 30, 31 der Fig. 2 eine größere Höhe H haben als die der Fig.1. Dadurch kann die Dünnglasfolienverbundbahn 1 der Fig. 2 nachteiligerweise zwar nur auf einer Rolle mit einem größeren Radius aufgewickelt werden, jedoch weist die Dünnglasfolienverbundbahn 1 gemäß Fig. 2 den Vorteil auf, dass die Versteifungsstreifen 30, 31 und die Dünnglasfolienbahn 10 nicht unter direktem Kontakt aneinander anliegen, so dass Toleranzen wie Säbeligkeit und Rauheit der Kanten 15, 16 der Dünnglasfolienbahn 10 wie auch entsprechende Ungenauigkeiten der Kanten der Versteifungsstreifen 30, 31 ausgeglichen werden. Ein weiterer Vorteil ist, dass beim Zusammenführen von der Dünnglasfolienbahn und der Schutzfolienbahn, mit der die Versteifungsstreifen verbunden sind, die Glasfolienkante nicht von den Versteifungsstreifen berührt wird und somit die Gefahr der Rissbildung verringert wird. Beim Aufrollen auf eine Rolle liegen die Dünnglasfolienbahnen 10 auch nicht mehr vollflächig auf der Schutzfolienbahn 20 des benachbarten radial inneren Wickels auf.

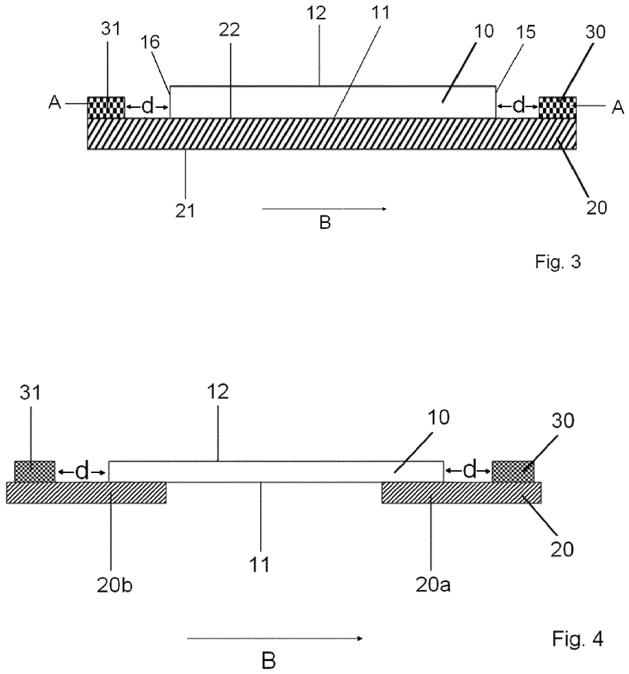

In der Ausführungsform der erfindungsgemäßen Dünnglasfolienverbundbahn 1 gemäß Fig. 3 ist die Dünnglasfolienbahn 10 wiederum entlang ihrer ersten Oberfläche 11 vollflächig mit der Schutzfolienbahn 20 beklebt. Die Schutzfolienbahn 20 steht auf beiden Seiten entlang der Breite B über die Kanten 15, 16 der Dünnglasfolienbahn 10 hinaus ab. Auf der zweiten Oberfläche 22 der Schutzfolienbahn 20 ist entlang der beiden Kanten 15, 16 jeweils einer der Versteifungsstreifen 30, 31 aufgebracht. Die Versteifungsstreifen 30, 31 bestehen gemäß Ausführungsform in Fig. 3 aus einem Material, das einen höheren E-Modul aufweist als die Materialien der Versteifungsstreifen 30, 31 der Figuren 1 und 2. Dadurch ist es möglich, die Versteifungsstreifen 30, 31 der Ausführungsform der Fig. 3 mit geringerer Querschnittsfläche A, insbesondere mit geringerer Höhe H, auszubilden, die aber dennoch die gleiche relative Zugsteifigkeit aufweisen wie die Versteifungsstreifen 30, 31 der Ausführungsformen der Figuren 1 und 2. Auch hier sind die beiden Versteifungsstreifen 30, 31 um jeweils den Abstand d von den Kanten 15, 16 der Dünnglasfolienbahn in Längsrichtung L geführt.

Vorteilhaft an der Ausführungsform der Fig. 3 ist die geringe Biegesteifigkeit, so dass der Biegeradius kleingehalten werden kann und somit ein leichtes und enges Aufwickeln der Dünnglasfolienverbundbahn 1 auf einer Rolle möglich ist. Darüber hinaus liegen die Dünnglasfolienbahnen 10 vollflächig auf der Schutzfolienbahn 20 des jeweils benachbarten Wickels der Rolle auf.

In Fig. 4 ist eine Ausführungsform gezeigt, bei der die Schutzfolienbahn 20 im Querschnitt entlang der Breite B nicht durchgängig ausgebildet ist. Die Schutzfolienbahn 20 besteht aus zwei Schutzfolienbahnstreifen 20a, 20b, die im Bereich der Kanten 15, 16 in Längsrichtung L auf die erste Oberfläche 11 der Dünnglasfolienbahn 10 aufgebracht sind, vorzugsweise aufgeklebt sind. In einer Dünnglasfolienebene ist entlang der beiden Kanten 15, 16 jeweils einer der Versteifungsstreifen 30, 31 aufgebracht. Beide Versteifungsstreifen 30, 31 sind um den Abstand d beabstandet von den Kanten 15, 16 entlang der Kanten 15, 16 geführt und weisen die gleiche Höhe H auf wie die Glasfolienbahn.

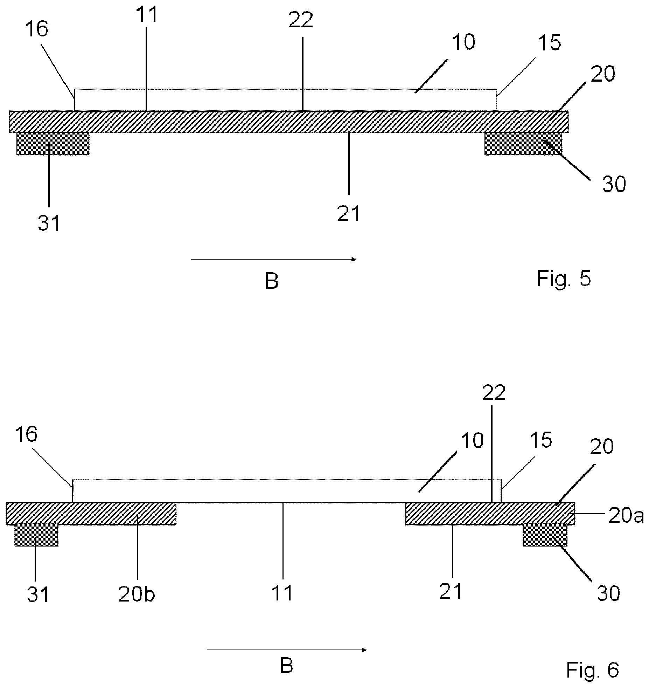

Die Figuren 5, 6 und 7 zeigen die Dünnglasfolienverbundbahn 1 mit auf der ersten Oberfläche aufgebrachter Schutzfolienbahn 20, die entlang der Breite B gemäß Ausführungsform der Fig. 6 unterbrochen sein kann. In allen drei Ausführungsformen sind die Versteifungsstreifen 30, 31 jedoch nicht auf der zweiten Oberfläche 22 der jeweiligen Schutzfolienbahn 20 aufgebracht, auf der auch die Dünnglasfolienbahn 10 aufgebracht ist, sondern auf der ihr gegenüberliegenden ersten Oberfläche 21. Die Versteifungsstreifen 30, 31 sind also der Dünnglasfolienbahn 10 gegenüberliegend an der Schutzfolienbahn 20 vorgesehen. Die Schutzfolienbahn 20 kann seitlich entlang der Breite B über die beiden Kanten 15, 16 der Dünnglasfolienbahn 10 hinaus abstehen. Dabei kann die Schutzfolienbahn 20 entlang der Breite B unterbrochen sein, wie Fig. 6 zeigt, und die zwei Schutzfolienbahnstreifen 20a, 20b aufweisen.

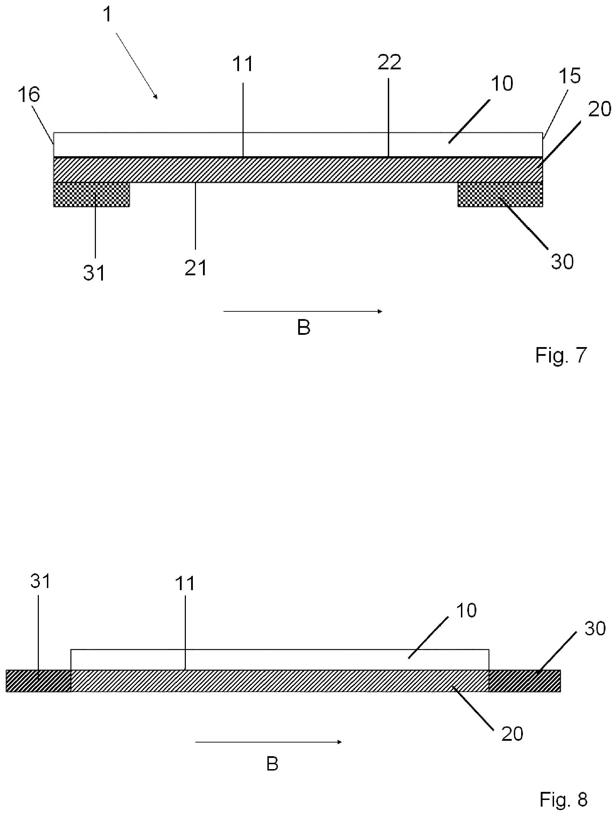

In den Ausführungsformen der Figuren 5, 6, 7 sind auf der ersten Oberfläche 21 der Schutzfolienbahn 20 die beiden Versteifungsstreifen 30, 31 in Längsrichtung L ausgerichtet aufgebracht. Fig. 7 zeigt eine Ausführungsform, bei der die Kanten 15, 16 der Dünnglasfolienbahn 10, die Kanten der Schutzfolienbahn 20 und die äußeren Kanten der Versteifungsstreifen 30, 31 miteinander fluchten und seitlich eine planare Begrenzung der Dünnglasfolienverbundbahn 1 ausbilden.

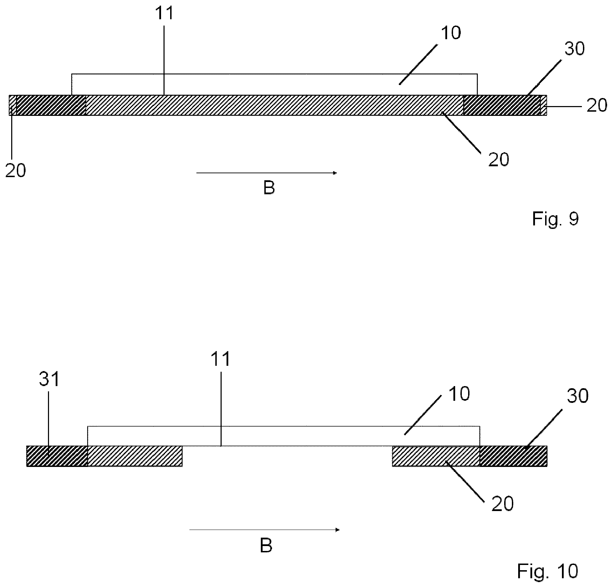

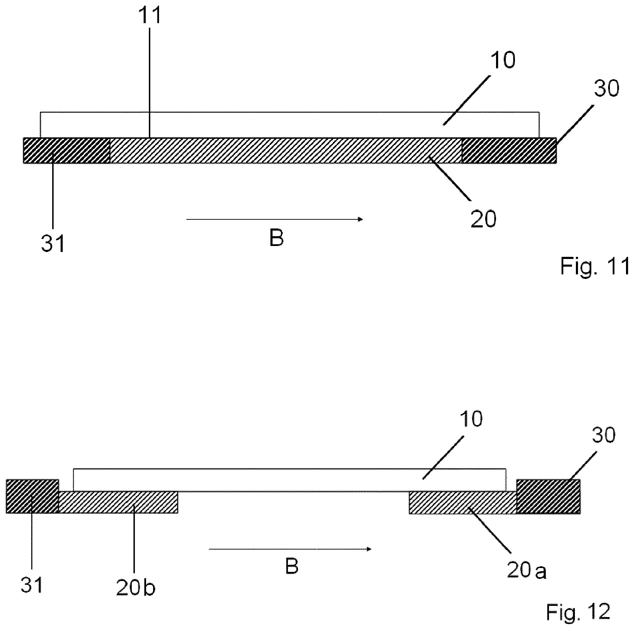

Die Fig. 8 bis 11 zeigen Ausführungsformen der erfindungsgemäßen Dünnglasfolienverbundbahn 1, bei denen die Versteifungsstreifen 30, 31 nicht in der Dünnglasfolienebene, sondern in der Schutzfolienebene angeordnet sind. Die Schutzfolienbahn 20 kann dabei im Querschnitt senkrecht zur Längsrichtung L wieder einteilig, d. h. die erste Oberfläche 11 der Dünnglasfolienbahn 10 vollflächig abdeckend, oder mehrbahnig gemäß Fig. 10 ausgebildet sein. Die beiden Versteifungsstreifen 30, 31 untergreifen die Dünnglasfolienbahn 10 entlang der ersten Oberfläche 11 in den Ausführungsformen gemäß Fig. 9 und 11 ein Stück weit, oder sie schließen mit den Kanten 15, 16 der Dünnglasfolienbahn 10 exakt ab, wie die Ausführungsformen in Fig. 8 und in Fig. 10 zeigen. In der Ausführungsform der Fig. 9 sind die beiden Versteifungsstreifen 30, 31 in die Schutzfolienbahn 20 entlang der Breite B integriert, so dass entlang der Breite B die beiden äußeren Kanten der Dünnglasfolienverbundbahn 1 durch die Schutzfolienbahn 20 ausgebildet werden. Die Höhe H der Versteifungsstreifen 30, 31 entspricht genau der Höhe H der Schutzfolienbahn 20.

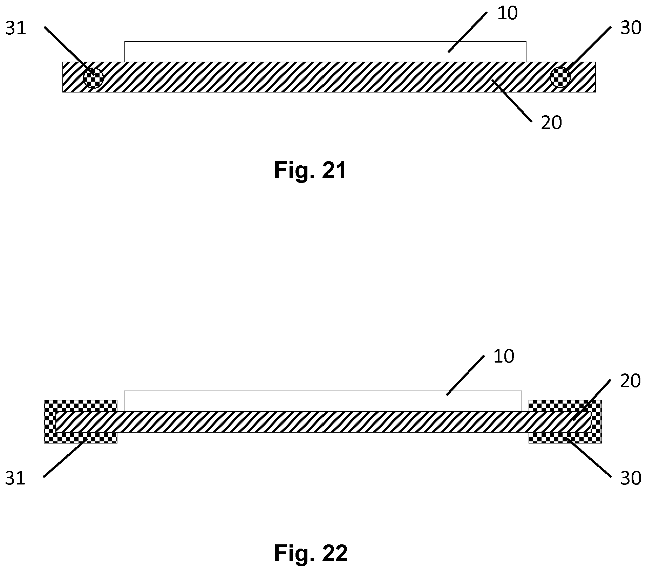

Fig. 21 zeigt eine Ausführungsform der erfindungsgemäßen Dünnglasfolienverbundbahn entsprechend den Ausführungen in Fig. 8 bis 11, bei der die Höhe H der Versteifungsstreifen 30, 31 geringer als die Höhe H der Schutzfolienbahn ausgeführt ist.

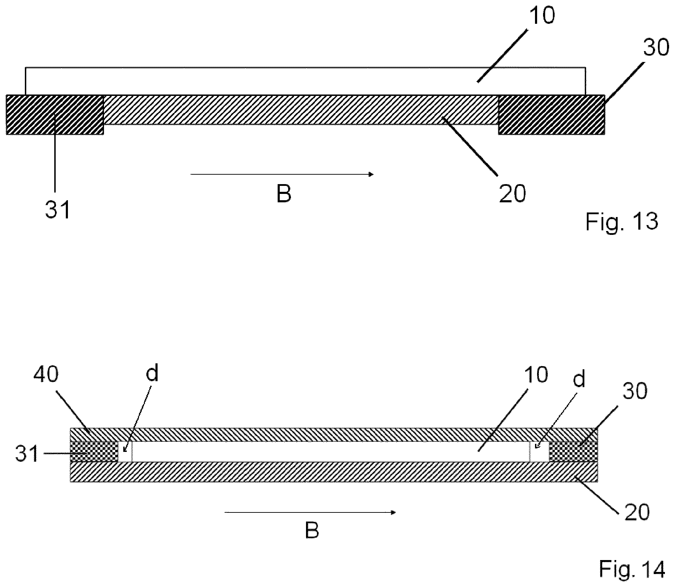

Die Figuren 12 und 13 zeigen Ausführungsformen der erfindungsgemäßen Dünnglasfolienverbundbahn 1, bei denen die beiden Versteifungsstreifen 30, 31 eine größere Höhe H aufweisen als die Schutzfolienbahn 20. Die Versteifungsstreifen 30, 31 können seitlich neben der Schutzfolienbahn 20 verlaufen und dabei in Richtung der Dünnglasfolienbahn 10 über die Schutzfolienbahn 20 herausragen oder gemäß Fig. 13 in Richtung weg von der Dünnglasfolienbahn 10 über die Schutzfolienbahn 20 hinausragen.

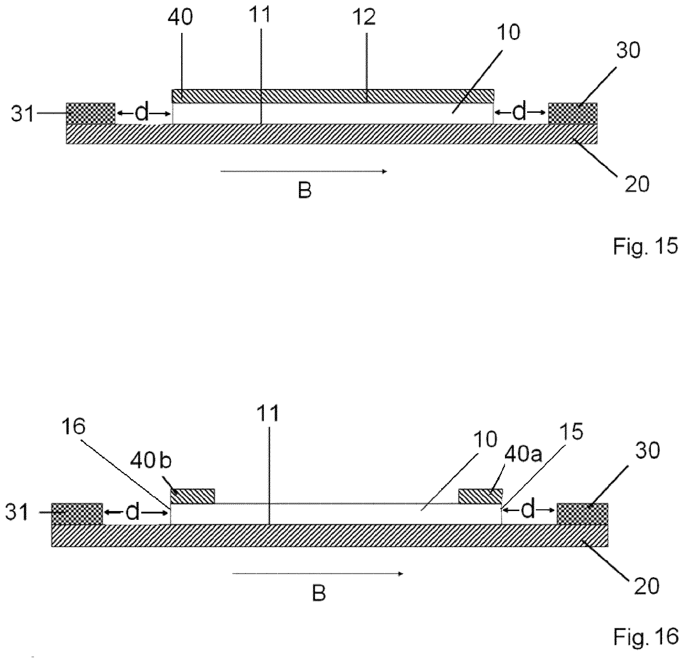

Die Figuren 14, 15 und 16 zeigen eine Ausführungsform der erfindungsgemäßen Dünnglasfolienverbundbahn 1 mit der Dünnglasfolienbahn 10 und den zwei Versteifungsstreifen 30, 31 in der Dünnglasfolienebene sowie der Schutzfolienbahn 20, die auf die erste Oberfläche 11 der Dünnglasfolienbahn 10 aufgebracht ist. Auf die zweite Oberfläche 12 der Dünnglasfolienbahn 10 ist in der Ausführungsform gemäß Figuren 14 und 15 eine weitere Schutzfolienbahn 40 aufgebracht, und in der Ausführungsform gemäß Fig. 16 sind zwei weitere Schutzfolienbahnstreifen 40a, 40b entlang der beiden Kanten 15, 16 aufgebracht. Die Schutzfolienbahn 40 beziehungsweise die beiden weiteren Schutzfolienbahnstreifen 40a, 40b weisen jedoch keine Versteifungsbereiche auf.

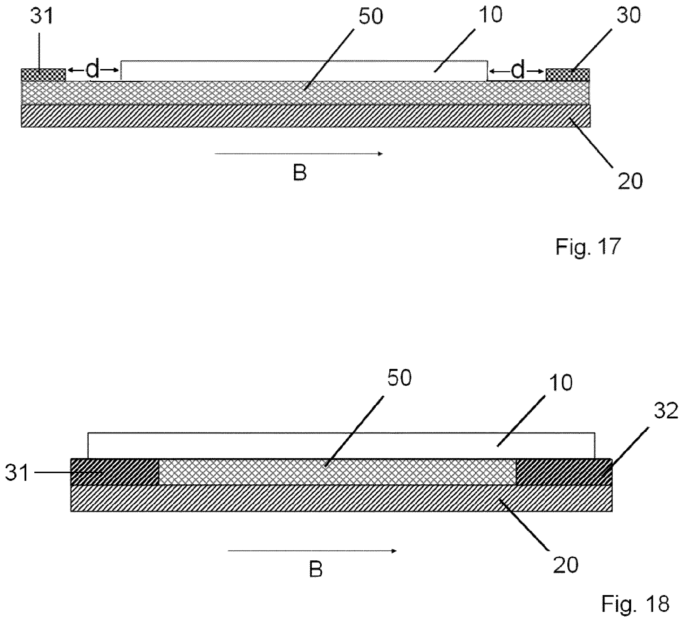

Figuren 17 und 18 zeigen eine Ausführungsform gemäß Fig. 3 beziehungsweise Fig. 11, wobei jedoch eine Klebemasseschicht 50 zwischen Schutzfolienbahn 20 und Dünnglasfolienbahn 10 beziehungsweise den beiden Versteifungsstreifen 30, 31 explizit eingezeichnet ist. Grundsätzlich können in allen oben genannten Ausführungsformen zwischen der Dünnglasfolienbahn 10 und der Schutzfolienbahn 20 sowie zwischen den Versteifungsstreifen 30, 31 und der Schutzfolienbahn 20 Klebemasseschichten 50 vorgesehen sein. Diese Klebemasseschichten 50 können bezüglich der Dünnglasfolienbahn 10 reversibel oder permanent sein. Sie können Silane enthalten, um einer Rissbildung in der Dünnglasfolienbahn 10 entgegenzuwirken oder um die Risse sogar zu reparieren.

Fig. 22 zeigt eine Ausführungsform der erfindungsgemäßen Dünnglasfolienverbundbahn entsprechend den Ausführungen in Fig. 3, 6 und 8, bei der die Versteifungsstreifen 30, 31 um die Kante der Schutzfolienbahn herumgefaltet sind und damit sowohl in der Ebene der Schutzfolienbahn, glasseitig auf der Schutzfolienbahn und glasabseitig auf der Schutzfolienbahn angeordnet sind.

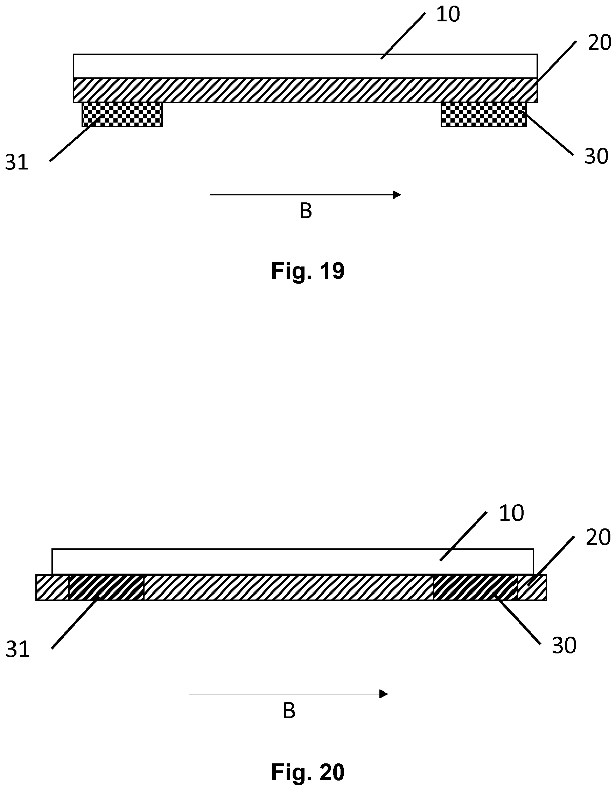

Fig. 19 stellt eine nicht erfindungsgemäße Ausführung einer Dünnglasfolienverbundbahn 1 dar, bei der die Dünnglasbahn 10 mit einer vollflächigen Schutzfolienbahn 20 abgedeckt ist, die Versteifungsstreifen 30, 31 auf der der Glasseite gegenüberliegenden Oberfläche der Schutzfolienbahn 20 aufweist. Die Projektionen der Versteifungsstreifen 30, 31 senkrecht zur Oberfläche der Dünnglasfolienbahn 10 in deren Ebene liegen dabei vollständig innerhalb der Fläche der Dünnglasfolienbahn 10 und sind damit in einem Abstand zur Glaskante angeordnet. Bei dieser Anordnung trägt primär die Glaskante die durch seitlichen Längszug aufgebrachten Lasten und ist daher stark bruchgefährdet.

Fig. 20 zeigt ebenfalls eine nicht erfindungsgemäße Ausführung einer Dünnglasfolienverbundbahn 1, bei denen die Versteifungsstreifen 30, 31 in der Schutzfolienebene angeordnet sind. Die Schutzfolienbahn 20 ist dabei im Querschnitt senkrecht zur Längsrichtung L einteilig ausgebildet. Die Projektionen der Versteifungsstreifen 30, 31 senkrecht zur Oberfläche der Dünnglasfolienbahn 10 in deren Ebene liegen dabei vollständig innerhalb der Fläche der Dünnglasfolienbahn 10 und sind damit in einem Abstand zur Glaskante angeordnet. Auch bei dieser Anordnung trägt primär die Glaskante die durch seitlichen Längszug aufgebrachten Lasten und ist daher stark bruchgefährdet.

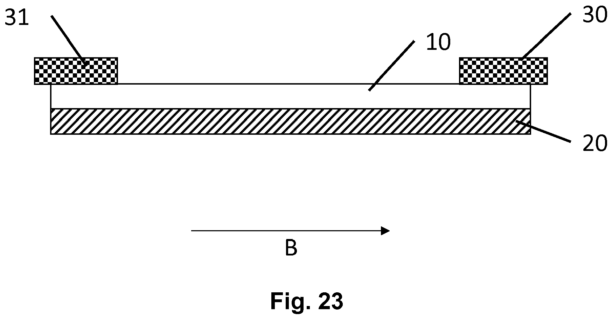

Figur 23 zeigt eine nicht erfindungsgemäße Ausführung der Dünnglasfolienverbundbahn 1, bei der die Schutzfolienbahn 20 und die Versteifungsstreifen 30, 31 nicht gemeinsam applizierbar sind. In diesem Fall sind sie auf verschiedenen Seiten der Dünnglasfolienbahn 10 angeordnet. Es kann somit nicht zunächst ein Verbund aus Schutzfolienbahn 20 und Versteifungsstreifen 30, 31 hergestellt werden, der dann mit der Dünnglasfolienbahn 10 in Kontakt gebracht werden könnte.

In einem vorteilhaften Verfahren wird die Schutzfolienbahn zusammen mit dem zumindest einen Versteifungsstreifen nach Verwendung des Dünnglasfolienverbundes, zum Beispiel zum Aufbau oder zur Verkapselung einer elektronischen Anordnung, von der Dünnglasfolie getrennt. In diesem Fall ist die Verwendung eines nicht permanenten Klebstoffs vorteilhaft.

In einem weiteren vorteilhaften Verfahren wird nur der zumindest eine Versteifungsstreifen nach Verwendung des Dünnglasfolienverbundes vom Dünnglasfolienverbund abgetrennt, wobei gegebenenfalls ein Teil der Schutzfolienbahn mit abgetrennt wird. Dies kann zum Beispiel durch seitlichen Kantenbeschnitt erfolgen. Besonders geeignet sind dafür Aufbauten bei denen der Versteifungsstreifen beabstandet von der Dünnglaskante angeordnet ist, etwa gemäß Figuren 2 bis 4, insbesondere 2 bis 4, 6, 12 sowie 14 bis 17, da hierbei der Versteifungsstreifen durch einen einfachen, durchgehenden Vertikalschnitt abgetrennt werden kann, ohne die Dünnglasbahn selbst schneiden zu müssen.

### Bezugszeichenliste

- 1: Dünnglasfolienverbundbahn

- 10: Dünnglasfolienbahn
- 11: erste Oberfläche der Dünnglasfolienbahn
- 12: zweite Oberfläche der Dünnglasfolienbahn

- 15: Kante der Dünnglasfolienbahn
- 16: Kante der Dünnglasfolienbahn

- 20: Schutzfolienbahn
- 20a: Schutzfolienbahnstreifen
- 20b: Schutzfolienbahnstreifen
- 21: erste Oberfläche der Schutzfolienbahn
- 22: zweite Oberfläche der Schutzfolienbahn

- 30: Versteifungsstreifen
- 31: Versteifungsstreifen

- 40: weitere Schutzfolienbahn
- 40a: Schutzfolienbahnstreifen
- 40b: Schutzfolienbahnstreifen

- 50: Klebemasseschicht

- d: Abstand

- A: Querschnittsfläche
- B: Breite
- H: Höhe
- L: Längsrichtung

## Patentansprüche

1. Dünnglasfolienverbundbahn mit einer Dünnglasfolienbahn (10) mit einer ersten (11) und einer zweiten Oberfläche (12) und zwei in einer Längsrichtung (L) verlaufenden Kanten (15, 16), einer Schutzfolienbahn (20) aus einem ersten Material, die sich entlang zumindest eines Teils der ersten Oberfläche (11) erstreckt,
mit zumindest einem entlang zumindest einer der beiden Kanten (15, 16) verlaufenden Versteifungsstreifen (30, 31) aus einem zweiten Material, das vom ersten Material verschieden ist,
wobei Schutzfolienbahn und Versteifungsstreifen derart miteinander verbunden sind, dass sie gemeinsam auf die Dünnglasbahn applizierbar sind,
und
**dadurch gekennzeichnet,**
**dass** der zumindest eine Versteifungsstreifen (30, 31) eine höhere relative Zugsteifigkeit aufweist als die Dünnglasfolienbahn (10).

2. Dünnglasfolienverbundbahn nach Anspruch 1,
**dadurch gekennzeichnet, dass**
der zumindest eine Versteifungsstreifen (30, 31) einen Elastizitätsmodul von E größer als 80 GPa aufweist.

3. Dünnglasfolienverbundbahn nach Anspruch 2,
**dadurch gekennzeichnet, dass**
der Elastizitätsmodul E größer als 100 GPa beträgt.

4. Dünnglasfolienverbundbahn nach zumindest einem der Ansprüche 1 bis 3,
**dadurch gekennzeichnet, dass**
das zweite Material S-Glasfasern, Kohlenstofffasern, Aramidfasern, Kohlenstoffnanoröhrchen, Graphen oder kristalline oder amorphe Mineralfasern und/oder eine Metallschicht umfassend Eisen, Stahl, Kupfer, Messing, Bronze, Titan, Nickel und deren Legierungen aufweist.

5. Dünnglasfolienverbundbahn nach zumindest einem der vorstehenden Ansprüche,
**dadurch gekennzeichnet, dass**
das erste Material Polyester, insbesondere Polyethylenterephthalat, Polyolefine, insbesondere Polybuten, Cyclo-Olefin-Copolymer, Polymethylpenten, Polypropylen oder Polyethylen oder deren Copolymere aufweist.

6. Dünnglasfolienverbundbahn nach zumindest einem der vorstehenden Ansprüche,
**dadurch gekennzeichnet, dass**
sich die Schutzfolienbahn (20) vollflächig entlang der ersten Oberfläche (11) erstreckt und/oder entlang beider Kanten (15, 16) der Dünnglasfolienbahn (10) über die Kanten (15, 16) entlang einer Ausdehnung entlang einer Breite hinaus absteht.

7. Dünnglasfolienverbundbahn nach zumindest einem der vorstehenden Ansprüche,
**dadurch gekennzeichnet, dass**
entlang beider Kanten (15, 16) der Dünnglasfolienbahn (10) jeweils einer der Versteifungsstreifen (30,31) entlang der gesamten Längsrichtung (L) der Kanten (15, 16) auf der der Dünnglasfolie zugewandten zweiten Seite der Schutzfolienbahn (20) angeordnet ist.

8. Dünnglasfolienverbundbahn nach zumindest einem der vorstehenden Ansprüche,
**dadurch gekennzeichnet, dass**
der zumindest eine Versteifungsstreifen (30, 31) beabstandet zu den Kanten (15, 16) der Dünnglasfolienbahn (10) angeordnet ist.

9. Dünnglasfolienverbundbahn nach zumindest einem der vorstehenden Ansprüche,
**dadurch gekennzeichnet, dass**
der zumindest eine Versteifungsstreifen (30, 31) eine gleiche oder geringere Höhe (H) über der Schutzfolienbahn (20) aufweist als die zweite Oberfläche (12) der Dünnglasfolienbahn (10).

10. Dünnglasfolienverbundbahn nach zumindest einem der vorstehenden Ansprüche,
**dadurch gekennzeichnet, dass**
der zumindest eine Versteifungsstreifen (30, 31) zumindest teilweise, bevorzugt vollständig in der Dünnglasfolienebene angeordnet ist.

11. Dünnglasfolienverbundbahn nach zumindest einem der vorstehenden Ansprüche,
**dadurch gekennzeichnet, dass**
der zumindest eine Versteifungsstreifen (30, 31) auf einer der Dünnglasfolienbahn (10) abgewandten ersten Seite der Schutzfolienbahn (20) aufgebracht ist.

12. Dünnglasfolienverbundbahn nach zumindest einem der vorstehenden Ansprüche,
**dadurch gekennzeichnet, dass**
der zumindest eine Versteifungsstreifen (30, 31) zumindest teilweise, bevorzugt vollständig in der Schutzfolienbahnebene angeordnet ist.

13. Dünnglasfolienverbundbahn nach zumindest einem der vorstehenden Ansprüche,
**dadurch gekennzeichnet, dass**
wenigstens eine weitere Schutzfolienbahn (40) auf der zweiten Oberfläche (12) der Dünnglasfolienbahn (10) vorhanden ist.

14. Dünnglasfolienverbundbahn nach zumindest einem der vorstehenden Ansprüche,
**dadurch gekennzeichnet, dass**
zwischen der Dünnglasfolienbahn (10) und der Schutzfolienbahn (20) eine Klebemasseschicht (50), insbesondere eine Haftklebstoffschicht, vorgesehen ist.

15. Dünnglasfolienverbundbahn nach zumindest einem der vorstehenden Ansprüche,
**dadurch gekennzeichnet, dass**
die Schutzfolienbahn (20) ein Klebeband mit zumindest einer Trägermaterialschicht und zumindest einer Klebstoffschicht und mit zumindest einem Versteifungsstreifen (30, 31) verbunden ist.

16. Dünnglasfolienverbundbahn nach zumindest einem der vorstehenden Ansprüche,
**dadurch gekennzeichnet, dass**
die Schutzfolienbahn (20) eine Barrierefunktion umfasst und damit eine Wasserdampfpermeationsrate von weniger als 1 g/m² d bei 38 °C und 90 % relativer Luftfeuchtigkeit aufweist.

17. Verfahren zur Lagerung von Dünnglasfolienbahnen (10), indem
die Dünnglasfolienbahn (10) mit einer ersten (11) und einer zweiten Oberfläche (12) und zwei in einer Längsrichtung verlaufenden Kanten (15, 16) zur Verfügung gestellt wird, eine Schutzfolienbahn (20) aus einem ersten Material entlang zumindest eines Teils der ersten Oberfläche (11) aufgebracht wird,
zumindest ein Versteifungsstreifen (30, 31) aus einem zweiten Material, das vom ersten Material verschieden ist und das eine höhere relative Zugsteifigkeit aufweist als die Dünnglasfolienbahn (10), entlang zumindest einer der beiden Kanten (15, 16) angeordnet wird,
wobei Schutzfolienbahn und Versteifungsstreifen derart miteinander verbunden sind, dass sie gemeinsam auf die Dünnglasbahn applizierbar sind.

18. Verfahren nach Anspruch 17,
**dadurch gekennzeichnet, dass**
die Schutzfolienbahn (20) mit dem Versteifungsstreifen (30, 31) versehen wird.

19. Verfahren nach Anspruch 17 oder 18,
**dadurch gekennzeichnet, dass**
als zweites Material S-Glasfasern, Kohlenstofffasern, Aramidfasern, Kohlenstoffnanoröhrchen, Graphen oder kristalline oder amorphe Mineralfasern und/oder eine Metallschicht umfassend Eisen, Stahl, Kupfer, Messing, Bronze, Titan, Nickel und deren Legierungen verwendet wird.

20. Verfahren nach einem der Ansprüche 17, 18 oder 19,
**dadurch gekennzeichnet, dass**
Polyester, insbesondere Polyethylenterephthalat, Polyolefine, insbesondere Polybuten, Cyclo-Olefin-Copolymer, Polymethylpenten, Polypropylen oder Polyethylen oder deren Copolymere als erstes Material verwendet wird.

21. Verfahren nach einem der Ansprüche 17 bis 20,
**dadurch gekennzeichnet, dass**
eine Dünnglasfolienverbundbahn (1) aus Dünnglasfolienbahn (10) und aufgeklebter Schutzfolienbahn (20) aufgerollt wird und wieder abgerollt wird und dass der zumindest eine Versteifungsstreifen vom Dünnglasfolienverbund abgetrennt wird, aber zumindest ein Teil der Schutzfolienbahn auf der Dünnglasfolienbahn verbleibt.

22. Verfahren nach einem der Ansprüche 17 bis 21,
**dadurch gekennzeichnet, dass**
eine Dünnglasfolienverbundbahn (1) aus Dünnglasfolienbahn (10) und aufgeklebter Schutzfolienbahn (20) aufgerollt wird und wieder abgerollt wird und die Schutzfolienbahn (20) dann von der Dünnglasfolienbahn (10) abgezogen wird.

23. Verfahren nach einem der Ansprüche 17 bis 22,
**dadurch gekennzeichnet, dass**
die Schutzfolienbahn (20) auf ihrer zweiten Oberfläche (22) mit einer Klebemasse (50) versehen wird und auf die erste Oberfläche (11) der Dünnglasfolienbahn aufgeklebt wird.

24. Verfahren nach Anspruch 23,
**dadurch gekennzeichnet, dass**
die Klebemasse (50) ein mit ihr unverträgliches Silan enthält.

25. Verfahren nach einem der Ansprüche 17 bis 24,
**dadurch gekennzeichnet, dass**
mehrere Schutzfolienbahnen (20) auf die Dünnglasfolienbahn (10) aufgebracht werden und nicht alle Schutzfolienbahnen (20) wieder von der Dünnglasfolienbahn (10) abgezogen werden.

26. Verfahren nach einem der Ansprüche 17 bis 25,
**dadurch gekennzeichnet, dass**
nur der zumindest eine Versteifungsstreifen nach Verwendung des Dünnglasfolienverbundes vom Dünnglasfolienverbund abgetrennt wird, wobei gegebenenfalls ein Teil der Schutzfolienbahn mit abgetrennt wird.

## Claims

1. Thin glass film composite web with a thin glass film web (10) having a first (11) and a second surface (12) and two edges (15, 16) running in a longitudinal direction (L) and a protective film web (20) of a first material extending along at least a portion of the first surface (11),
having
at least one reinforcing strip (30, 31) running along at least one of the two edges (15, 16) of a second material that is different from the first material,
wherein the protective film web and the reinforcing strips are connected to one another such that they can be applied together to the thin glass web,
and
**characterized**
**in that** the at least one reinforcing strip (30, 31) has a higher relative tensile strength than the thin glass film web (10).

2. Thin glass film composite web according to Claim 1,
**characterized in that**
the at least one reinforcing strip (30, 31) has an elastic modulus E of greater than 80 GPa.

3. Thin glass film composite web according to Claim 2,
**characterized in that**
the elastic modulus E is greater than 100 GPa.

4. Thin glass film composite web according to at least one of Claims 1 to 3,
**characterized in that**
the second material comprises S-glass fibers, carbon fibers, aramid fibers, carbon nanotubes, graphene, or crystalline or amorphous mineral fibers and/or a metal layer comprising iron, steel, copper, brass, bronze, titanium, nickel and alloys thereof.

5. Thin glass film composite web according to at least one of the preceding claims,
**characterized in that**
the first material comprises polyester, particularly polyethylene terephthalate, polyolefins, particularly polybutene, cycloolefin copolymer, polymethyl pentene, polypropylene, or polyethylene or copolymers thereof.

6. Thin glass film composite web according to at least one of the preceding claims,
**characterized in that**
the protective film web (20) extends entirely over the first surface (11) and/or protrudes beyond the edges (15, 16) along an extent along a width on both edges (15, 16) of the thin glass film web (10) .

7. Thin glass film composite web according to at least one of the preceding claims,
**characterized in that**
one each of the reinforcing strips (30, 31) is arranged along both edges (15, 16) of the thin glass film web (10) along the entire longitudinal direction (L) of the edges (15, 16) on the second side of the protective film web (20) facing toward the thin glass film.

8. Thin glass film composite web according to at least one of the preceding claims,
**characterized in that**
the at least one reinforcing strip (30, 31) is arranged at a distance from the edges (15, 16) of the thin glass film web (10).

9. Thin glass film composite web according to at least one of the preceding claims,
**characterized in that**
the at least one reinforcing strip (30, 31) has an equal or lower height (H) above the protective film web (20) than the second surface (12) of the thin glass film web (10).

10. Thin glass film composite web according to at least one of the preceding claims,
**characterized in that**
the at least one reinforcing strip (30, 31) is arranged at least partially, preferably entirely, in the thin glass film layer.

11. Thin glass film composite web according to at least one of the preceding claims,
**characterized in that**
the at least one reinforcing strip (30, 31) is applied on a first side of the protective film web (20) facing away from the thin glass film web (10).

12. Thin glass film composite web according to at least one of the preceding claims,
**characterized in that**
the at least one reinforcing strip (30, 31) is arranged at least partially, preferably entirely, in the protective film web layer.

13. Thin glass film composite web according to at least one of the preceding claims,
**characterized in that**
at least one further protective film web (40) is present on the second surface (12) of the thin glass film web (10).

14. Thin glass film composite web according to at least one of the preceding claims,
**characterized in that**
an adhesive layer (50), particularly a pressure-sensitive adhesive layer, is arranged between the thin glass film web (10) and the protective film web (20).

15. Thin glass film composite web according to at least one of the preceding claims,
**characterized in that**
the protective film web (20) an adhesive tape with at least one carrier material layer, and at least one adhesive layer, and is connected to at least one reinforcing strip (30, 31).

16. Thin glass film composite web according to at least one of the preceding claims,
**characterized in that**
the protective film web (20) comprises a barrier function and thus has a water vapor permeation rate of less than 1 g/m² d at 38°C and 90% relative humidity.

17. Method for the storage of thin glass film webs (10), by providing the thin glass film web (10) with a first (11) and a second surface (12) and two edges (15, 16) running in a longitudinal direction, applying a protective film web (20) of a first material along at least a portion of the first surface (11),
arranging at least one reinforcing strip (30, 31) of a second material that is different from the first material and has a higher relative tensile strength than the thin glass film web (10) along at least one of the two edges (15, 16),
wherein the protective film web and reinforcing strips are connected to one another such that they can be applied together to the thin glass web.

18. Method according to Claim 17,
**characterized in that**
the protective film web (20) is provided with the reinforcing strip (30, 31).

19. Method according to Claim 17 or 18,
**characterized in that**
S-glass fibers, carbon fibers, aramid fibers, carbon nanotubes, graphene, or crystalline or amorphous mineral fibers and/or a metal layer comprising iron, steel, copper, brass, bronze, titanium, nickel and alloys thereof are used as a second material.

20. Method according to one of Claims 17, 18 or 19,
**characterized in that**
polyester, particularly polyethylene terephthalate, polyolefins, particularly polybutene, cycloolefin copolymer, polymethyl pentene, polypropylene or polyethylene or copolymers thereof are used as a first material.

21. Method according to one of Claims 17 to 20,
**characterized in that**
a thin glass film composite web (1) of a thin glass film web (10) and a glued-on protective film web (20) is rolled up and then unrolled and **in that** the at least one reinforcing strip is separated from the thin glass film composite, but at least a part of the protective film web remains on the thin glass film web.

22. Method according to one of Claims 17 to 21,
**characterized in that**
a thin glass film composite web (1) of the thin glass film web (10) and the glued-on protective film web (20) is rolled up and then unrolled and the protective film web (20) is then removed from the thin glass film web (10).

23. Method according to one of Claims 17 to 22,
**characterized in that**
the protective film web (20) is provided on its second surface (22) with an adhesive (50) and is glued onto the first surface (11) of the thin glass film web.

24. Method according to Claim 23,
**characterized in that**
the adhesive (50) contains a silane that is incompatible therewith.

25. Method according to one of Claims 17 to 24,
**characterized in that**
multiple protective film webs (20) are applied to the thin glass film web (10), and not all of the protective film webs (20) are again removed from the thin glass film web (10).

26. Method according to one of Claims 17 to 25,
**characterized in that**
only the at least one reinforcing strip is separated from the thin glass film composite after use of said thin glass film composite, wherein a part of the protective film web is optionally also removed.

## Revendications

1. Bande composite à feuille de verre mince comprenant une bande de feuille de verre mince (10) munie d'une première (11) et d'une deuxième surface (12) et de deux bords (15, 16) qui s'étendent dans une direction longitudinale (L), une bande de feuille de protection (20) en un premier matériau, qui s'étend le long d'au moins une partie de la première surface (11), comprenant au moins une bande de renforcement (30, 31) en un deuxième matériau, qui est différent du premier matériau, laquelle s'étend le long d'au moins un des deux bords (15, 16),
la bande de feuille de protection et la bande de renforcement étant reliées l'une avec l'autre de telle sorte qu'elles puissent être appliquées ensemble sur la bande de verre mince,
**caractérisée en ce que**
ladite au moins une bande de renforcement (30, 31) présente une rigidité à la traction relative plus élevée que la bande de feuille de verre mince (10).

2. Bande composite à feuille de verre mince selon la revendication 1, **caractérisée en ce que** ladite au moins une bande de renforcement (30, 31) présente un module d'élasticité E supérieur à 80 GPa.

3. Bande composite à feuille de verre mince selon la revendication 2, **caractérisée en ce que** le module d'élasticité E est supérieur à 100 GPa.

4. Bande composite à feuille de verre mince selon au moins l'une quelconque des revendications 1 à 3,
**caractérisée en ce que** le deuxième matériau comprend des fibres de verre S, des fibres de carbone, des fibres d'aramide, des nanotubes de carbone, du graphène ou des fibres minérales cristallines ou amorphes et/ou une couche métallique comprenant du fer, de l'acier, du cuivre, du laiton, du bronze, du titane, du nickel et leurs alliages.

5. Bande composite à feuille de verre mince selon au moins l'une quelconque des revendications précédentes,
**caractérisée en ce que** le premier matériau comprend des polyesters, notamment du polyéthylène téréphtalate, des polyoléfines, notamment du polybutène, un copolymère de cyclooléfine, du polyméthylpentène, du polypropylène ou du polyéthylène ou leurs copolymères.

6. Bande composite à feuille de verre mince selon au moins l'une quelconque des revendications précédentes,
**caractérisée en ce que** la bande de feuille de protection (20) s'étend le long de la première surface (11) sur l'ensemble de la surface et/ou dépasse le long des deux bords (15, 16) de la bande de feuille de verre mince (10) au-delà des bords (15, 16) le long d'une étendue le long d'une largeur.

7. Bande composite à feuille de verre mince selon au moins l'une quelconque des revendications précédentes,
**caractérisée en ce qu'**une des bandes de renforcement (30, 31) est agencée le long de chacun des deux bords (15, 16) de la bande de feuille de verre mince (10) le long de la direction longitudinale totale (L) des bords (15, 16) sur le deuxième côté de la bande de feuille de protection (20) orienté vers la feuille de verre mince.

8. Bande composite à feuille de verre mince selon au moins l'une quelconque des revendications précédentes,
**caractérisée en ce que** ladite au moins une bande de renforcement (30, 31) est agencée espacée des bords (15, 16) de la bande de feuille de verre mince (10).

9. Bande composite à feuille de verre mince selon au moins l'une quelconque des revendications précédentes,
**caractérisée en ce que** ladite au moins une bande de renforcement (30, 31) présente une hauteur (H) au-dessus de la bande de feuille de protection (20) égale ou inférieure à la deuxième surface (12) de la bande de feuille de verre mince (10).

10. Bande composite à feuille de verre mince selon au moins l'une quelconque des revendications précédentes,
**caractérisée en ce que** ladite au moins une bande de renforcement (30, 31) est au moins partiellement, de préférence entièrement, agencée dans le plan de la feuille de verre mince.

11. Bande composite à feuille de verre mince selon au moins l'une quelconque des revendications précédentes,
**caractérisée en ce que** ladite au moins une bande de renforcement (30, 31) est appliquée sur un premier côté de la bande de feuille de protection (20) opposé à la bande de feuille de verre mince (10).

12. Bande composite à feuille de verre mince selon au moins l'une quelconque des revendications précédentes,
**caractérisée en ce que** ladite au moins une bande de renforcement (30, 31) est au moins partiellement, de préférence entièrement, agencée dans le plan de la bande de feuille de protection.

13. Bande composite à feuille de verre mince selon au moins l'une quelconque des revendications précédentes,
**caractérisée en ce qu'**au moins une bande de feuille de protection supplémentaire (40) est présente sur la deuxième surface (12) de la bande de feuille de verre mince (10).

14. Bande composite à feuille de verre mince selon au moins l'une quelconque des revendications précédentes,
**caractérisée en ce qu'**une couche de masse adhésive (50), notamment une couche d'adhésif sensible à la pression, est prévue entre la bande de feuille de verre mince (10) et la bande de feuille de protection (20).

15. Bande composite à feuille de verre mince selon au moins l'une quelconque des revendications précédentes,
**caractérisée en ce que** la bande de feuille de protection (20) est une bande adhésive avec au moins une couche de matériau support et au moins une couche d'adhésif, et est reliée avec au moins une bande de renforcement (30, 31).

16. Bande composite à feuille de verre mince selon au moins l'une quelconque des revendications précédentes,
**caractérisée en ce que** la bande de feuille de protection (20) comprend une fonction de barrière, et présente ainsi un taux de perméation de la vapeur d'eau de moins de 1 g/m² j à 38 °C et 90 % d'humidité relative de l'air.

17. Procédé de stockage de bandes de feuille de verre mince (10), selon lequel
la bande de feuille de verre mince (10) munie d'une première (11) et d'une deuxième surface (12) et de deux bords (15, 16) qui s'étendent dans une direction longitudinale est mise à disposition, une bande de feuille de protection (20) en un premier matériau est appliquée le long d'au moins une partie de la première surface (11),
au moins une bande de renforcement (30, 31) en un deuxième matériau, qui est différent du premier matériau et qui présente une rigidité à la traction relative plus élevée que la bande de feuille de verre mince (10), est agencée le long d'au moins un des deux bords (15, 16),
la bande de feuille de protection et la bande de renforcement étant reliées l'une avec l'autre de telle sorte qu'elles puissent être appliquées ensemble sur la bande de verre mince.

18. Procédé selon la revendication 17, **caractérisé en ce que** la bande de feuille de protection (20) est munie de la bande de renforcement (30, 31).

19. Procédé selon la revendication 17 ou 18,
**caractérisé en ce que** des fibres de verre S, des fibres de carbone, des fibres d'aramide, des nanotubes de carbone, du graphène ou des fibres minérales cristallines ou amorphes et/ou une couche métallique comprenant du fer, de l'acier, du cuivre, du laiton, du bronze, du titane, du nickel et leurs alliages sont utilisés en tant que deuxième matériau.

20. Procédé selon l'une quelconque des revendications 17, 18 ou 19, **caractérisé en ce que** des polyesters, notamment du polyéthylène téréphtalate, des polyoléfines, notamment du polybutène, un copolymère de cyclooléfine, du polyméthylpentène, du polypropylène ou du polyéthylène ou leurs copolymères sont utilisés en tant que premier matériau.

21. Procédé selon l'une quelconque des revendications 17 à 20, **caractérisé en ce qu'**une bande composite à feuille de verre mince (1) constituée par une bande de feuille de verre mince (10) et une bande de feuille de protection collée (20) est enroulée et de nouveau déroulée, et **en ce que** ladite au moins une bande de renforcement est séparée du composite à feuille de verre mince, mais au moins une partie de la bande de feuille de protection reste sur la bande de feuille de verre mince.

22. Procédé selon l'une quelconque des revendications 17 à 21, **caractérisé en ce qu'**une bande composite à feuille de verre mince (1) constituée par une bande de feuille de verre mince (10) et une bande de feuille de protection collée (20) est enroulée et de nouveau déroulée, et la bande de feuille de protection (20) est ensuite retirée de la bande de feuille de verre mince (10) .

23. Procédé selon l'une quelconque des revendications 17 à 22, **caractérisé en ce que** la bande de feuille de protection (20) est munie sur sa deuxième surface (22) d'une masse adhésive (50), et collée sur la première surface (11) de la bande de feuille de verre mince.

24. Procédé selon la revendication 23, **caractérisé en ce que** la masse adhésive (50) contient un silane incompatible avec celle-ci.

25. Procédé selon l'une quelconque des revendications 17 à 24, **caractérisé en ce que** plusieurs bandes de feuille de protection (20) sont appliquées sur la bande de feuille de verre mince (10) et toutes les bandes de feuille de protection (20) ne sont pas retirées de la bande de feuille de verre mince (10).

26. Procédé selon l'une quelconque des revendications 17 à 25, **caractérisé en ce que** seule ladite au moins une bande de renforcement est séparée du composite à feuille de verre mince après l'utilisation du composite à feuille de verre mince, une partie de la bande de feuille de protection étant éventuellement séparée avec celle-ci.
